(19) **Europäisches Patentamt**

**European Patent Office**

**Office européen des brevets**

(11) **EP 1 617 477 A1**

(12) **EUROPEAN PATENT APPLICATION**
published in accordance with Art. 158(3) EPC

(43) Date of publication:
**18.01.2006 Bulletin 2006/03**

(51) Int Cl.:
*H01L 27/092* (1990.01)    *H01L 27/06* (1974.07)
*H01L 29/786* (1995.01)

(21) Application number: **04719623.3**

(22) Date of filing: **11.03.2004**

(86) International application number:
**PCT/JP2004/003208**

(87) International publication number:
**WO 2004/088750 (14.10.2004 Gazette 2004/42)**

(84) Designated Contracting States:
**AT BE BG CH CY CZ DE DK EE ES FI FR GB GR
HU IE IT LI LU MC NL PL PT RO SE SI SK TR**
Designated Extension States:
**AL LT LV MK**

(30) Priority: **31.03.2003 JP 2003095116**

(71) Applicant: **Juridical Foundation Osaka Industrial
Promotion
Organization
Osaka-shi,
osaka 540-0029 (JP)**

(72) Inventor: **AKINO, Toshiro,
c/o Kinki University
Naga-gun,
Wakayama 649 (JP)**

(74) Representative: **Potter, Julian Mark et al
Mintz Levin Cohn Ferris Glovsky and Popeo
Intellectual Property LLP,
The Rectory,
9 Ironmonger Lane
London EC2V 8EY (GB)**

(54) **LATERAL BIPOLAR CMOS INTEGRATED CIRCUIT**

(57)    A lateral bipolar CMOS integrated circuit having an inverter circuit including an n-channel MOS transistor and a p-channel MOS transistor, and having four terminals of: a gate input terminal Vin connected with the gates of the n-channel MOS transistor and the p-channel MOS transistor; an output terminal Vout connected with the drains of the n-channel MOS transistor and the p-channel MOS transistor; a p-type base terminal connected with a p-type substrate of the n-channel MOS transistor; and an n-type base terminal connected with an n-type substrate of the p-channel MOS transistor. The n-channel MOS transistor operates in a hybrid mode which is the hybrid of an operation mode of the MOS transistor and that of an npn lateral bipolar transistor which is inherent in the n-channel MOS transistor. The p-channel MOS transistor operates in a hybrid mode which is the hybrid of an operation mode of the MOS transistor and that of a pnp lateral bipolar transistor which is inherent in the p-channel MOS transistor.

Fig.1

**Description**

FIELD OF THE INVENTION

The present invention relates to a CMOS integrated circuit, and more particularly, to a lateral bipolar CMOS integrated circuit in which a 4-terminal MOS transistor and an inherent lateral bipolar transistor operate in a hybrid mode.

BACKGROUND OF THE INVENTION

Although a CMOS integrated circuit is characterized in not increasing the consumption power density almost at all despite an enhanced degree of scaling, as the degree of integration increases, the amount of current does not increase owing to the effect of carrier velocity saturation even when the channel length is further shortened, and therefore, the current driving force does not increase. Meanwhile, the increased degree of integration of the CMOS integrated circuit increases the wiring RC load and the fan-out capacity load. Hence, the CMOS integrated circuit which does not carry more current even despite the shortened channel length can not deal with the integration-induced increase of the loads due to the wiring complexity and requires a device which has larger current driving force.
In contrast to this, a DTMOS (Dynamic Threshold Voltage MOS) transistor has been proposed in which a MOS transistor and a lateral bipolar transistor inherent to the same operation in a hybrid mode. In a DTMOS transistor, application of an input voltage upon an n-channel gate terminal of a MOS transistor simultaneously corresponds to application of a forward voltage upon a base-emitter junction (base-source junction) of an inherent npn transistor. In other words, a gate voltage triggers a base current, a large collector current which is current amplification factor times as large as the base current is obtained and the current driving force therefore increases (F. Assaderaghi et al., "A Dynamic Threshold Voltage MOSFET (DTMOS) for Very Low Voltage Operation," IEEE Electron Device Letters, vol. 15, pp.510 - 512, December 1994).
However, a DTMOS transistor has the following problems. That is, where Vdd is higher than 0.7 V, an exponential forward current flows between the base and the emitter, the DTMOS transistor malfunctions and can not be used. Further, even when Vdd is 0.7 V, the DTMOS transistor consumes large power. In addition, where Vdd is lower than 0.7 V, the current driving force decreases and the DTMOS transistor flows a forward current which is large enough not to be ignored.

SUMMARY OF THE INVENTION

The present invention aims at providing a low-energy CMOS integrated circuit which is capable of operating at a high speed.
In short, the present invention is directed to a lateral bipolar CMOS integrated circuit including an inverter circuit in which an n-channel MOS transistor and a p-channel MOS transistor are disposed, and has four terminals which are: a gate input terminal Vin which is connected with the gates of the n-channel MOS transistor and the p-channel MOS transistor; an output terminal Vout which is connected with the drains of the n-channel MOS transistor and the p-channel MOS transistor; a p-type base terminal which is connected with a p-type substrate of the n-channel MOS transistor; and an n-type base terminal which is connected with an n-type substrate of the p-channel MOS transistor, wherein the n-channel MOS transistor operates in a hybrid mode which is the hybrid of an operation mode of the MOS transistor and that of an npn lateral bipolar transistor which is inherent in the n-channel MOS transistor, and the p-channel MOS transistor operates in a hybrid mode which is the hybrid of an operation mode of the MOS transistor and that of a pnp lateral bipolar transistor which is inherent in the p-channel MOS transistor.
A conventional 3-terminal DTMOS transistor, while having a problem that it consumes large power and can not be used where Vdd is higher than 0.7 V, is characterized in that it is extremely fast because of its current driving force during a lateral bipolar transistor operation. Noting this, the present invention aims at utilizing this driving force and provides an integrated circuit in which a MOS transistor designed assuming use of SOI and a lateral bipolar transistor which is inherent in the structure are treated as a hybrid 4-terminal element.
The present invention is directed further to a lateral bipolar CMOS integrated circuit including the inverter circuit above wherein the gate input terminal Vin, the p-type base terminal and the n-type base terminal are input terminals of the inverter circuit, and the output terminal Vout is an output terminal of the inverter circuit, and the inverter circuit outputs, at the output terminal Vout, a high-level or low-level voltage fed to the gate input terminal Vin as an inverted level voltage.
The present invention is directed further to the lateral bipolar CMOS integrated circuit above including a current source Ibp connected with the p-type base terminal of the n-channel MOS transistor and a current source Ibn connected with the n-type base terminal of the p-channel MOS transistor, wherein currents from the current sources Ibp and Ibn are maintained at 0 when the input voltage to the gate input terminal Vin is approximately constant at a high level or low level, when the input voltage to the gate input terminal Vin switches from a low level to a high level, a forward pulse current flows from the current source Ibp to the p-type base terminal in synchronization to switching, and when the input voltage to the gate input terminal Vin switches from the high level to the low level, a forward pulse current flows from the current source Ibn to the n-type base terminal in synchronization to switching.

The present invention is directed further to the lateral bipolar CMOS integrated circuit above further including a voltage source Vdd and a ground source Gnd, wherein the current source Ibp is formed by a pull-up p-channel MOS transistor including a source terminal, a drain terminal and a substrate terminal, the drain terminal is connected with the p-type base terminal, and the source terminal and the substrate terminal are connected with the voltage source Vdd, and the current source Ibn is formed by a pull-down n-channel MOS transistor including a source terminal, a drain terminal and a substrate terminal, the drain terminal is connected with the n-type base terminal, and the source terminal and the substrate terminal are connected with the ground source Gnd.

The present invention is directed further to the lateral bipolar CMOS integrated circuit above wherein the inverter circuit including the n-channel MOS transistor and the p-channel MOS transistor is used as a CMOS standard cell in the operation mode of the MOS transistor, but is used in the hybrid mode when a large load is connected with an output from the CMOS standard cell.

As clearly described above, the 4-terminal n-channel and p-channel MOS transistors and the npn and pnp lateral bipolar transistors which are inherent in these structures operate in the hybrid mode in the lateral bipolar CMOS integrated circuit according to the present invention, and therefore, the lateral bipolar CMOS integrated circuit is capable of operating at a high speed while requiring lower energy as high-speed charge and discharge is attained only when the inverter circuit switches.

BRIEF DESCRIPTION OF THE DRAWINGS

Fig. 1 schematically shows the cross section of a lateral bipolar CMOS circuit according to an embodiment;
Fig. 2 shows an equivalent circuit to the lateral bipolar CMOS inverter circuit (LBCMOS) according to the embodiment;
Fig. 3 shows an equivalent circuit to an n-channel MOS transistor;
Fig. 4 shows an equivalent circuit to a p-channel MOS transistor;
Fig. 5 shows the layout of the LBCMOS according to the embodiment;
Fig. 6 shows the waveforms of an input voltage and currents supplied from Ibp and Ibn;
Fig. 7 shows an equivalent circuit to the lateral bipolar CMOS inverter circuit (LBCMOS) according to the embodiment;
Fig. 8 shows the layout of the LBCMOS according to the embodiment;
Fig. 9 shows the waveforms of the input voltage and gate voltages Vp and Vn;
Fig. 10 shows an equivalent circuit to a conventional DTMOS according to an example for comparison;
Fig. 11 shows an equivalent circuit to an n-channel DTMOS;
Fig. 12 shows an equivalent circuit to a p-channel DTMOS;
Fig. 13 shows the pulse waveform of the input voltage;
Fig. 14 shows a current Ids - voltage Vds characteristic of the n-channel DTMOS as it is when Vgs changes;
Fig. 15 shows a current |Ids| - voltage |Vds| characteristic of the p-channel DTMOS as it is when |Vgs| changes;
Figs. 16A and 16B show the time delay and the consumption power in a DTCMOS;
Figs. 17A and 17B show the energy and the energy-delay product in a DTCMOS;
Fig. 18 shows a current Ids - voltage Vds characteristic of an n-channel LBMOS as it is when Vbe = 0.7 V and Vgs changes;
Fig. 19 shows a current Ids - voltage Vgs characteristic of an n-channel LBMOS as it is when Vbe = 0.7 V and Vds = 1.0 V;
Fig. 20 shows a current |Ids| - voltage |vds| characteristic of an n-channel LBMOS as it is when |Vbe| = 0.7 V and |vgs| changes;
Fig. 21 shows a current |Ids| - voltage |Vgs| characteristic of a p-channel LBMOS as it is when |Vbe| = 0.7 V and |Vds| = 1.0 V;
Figs. 22A and 22B show comparisons of a LBCMOS inverter circuit against a CMOS and a DTCMOS in terms of the time delay and the consumption power;
Figs. 23A and 23B show comparisons of a LBCMOS inverter circuit against a CMOS and a DTCMOS in terms of the energy and the energy-delay product;
Figs. 24A and 24B show comparisons of a LBCMOS inverter circuit against a CMOS in terms of the time delay and the consumption power;
Figs. 25A and 25B show comparisons of a LBCMOS inverter circuit against a CMOS in terms of the energy and the energy-delay product;
Figs. 26A and 26B show the relation between the time delay and the consumption power in a LBCMOS inverter circuit;
Figs. 27A and 27B show the relation between the energy and the energy-delay product in a LBCMOS inverter circuit;

Figs. 28A and 28B show the relation between the relation between the time delay and the consumption power in a LBCMOS inverter circuit;

Figs. 29A and 29B show the relation between the energy and the energy-delay product in a LBCMOS inverter circuit;

Figs. 30A and 30B show the relation between the time delay and the consumption power in a LBCMOS inverter circuit;

Figs. 31A and 31B show the relation between the energy and the energy-delay product in a LBCMOS inverter;

Figs. 32A and 32B show the relation between the time delay and the consumption power in a LBCMOS inverter circuit;

Figs. 33A and 33B show the relation between the energy and the energy-delay product in a LBCMOS inverter circuit;

Figs. 34A and 34B show the relation between the time delay and the consumption power in a LBCMOS inverter circuit; and

Figs. 35A and 35B show the relation between the energy and the energy-delay product in a LBCMOS inverter circuit.

BEST MODE FOR CARRYING OUT THE INVENTION

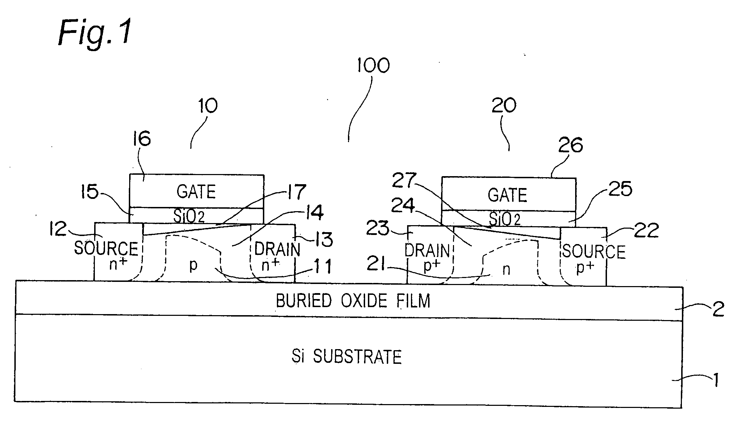

Fig. 1 schematically shows the cross section view of a lateral bipolar CMOS (Lateral Bipolar CMOS) inverter circuit (hereinafter referred to as "LBCMOS") according to an embodiment generally denoted at 100.

The LBCMOS 100 has a silicon substrate 1. An n-channel MOS transistor 10 and a p-channel MOS transistor 20 are formed on the silicon substrate 1 via a buried oxide film 2 of silicon oxide.

The n-channel MOS transistor 10 has a p-type substrate region 11 and n-type source region 12 and an n-type drain region 13 which are on the both sides to the p-type substrate region 11. These regions 11, 12 and 13 are made of silicon. The p-type substrate region 11 is designed to have such a film thickness and an impurity concentration which will create a partial depletion layer 14.

A gate electrode 16 of polycrystalline silicon is disposed on the p-type substrate region 11 via a gate insulation film 15 of silicon oxide. Application of a voltage upon the gate electrode 16 develops an n-channel (inversion layer) 17 in the p-type substrate region 11.

The p-channel MOS transistor 20 is further disposed on the buried oxide film 2. The structure of the p-channel MOS transistor 20 is approximately the same as that of the n-channel MOS transistor 10. There are an n-type substrate region 21 and a p-type source region 22 and a p-type drain region 23 which are on the both sides to the n-type substrate region 21 are formed on the buried oxide film 2, and a gate electrode 26 is further disposed on the n-type substrate region 21 via a gate insulation film 25. A partial depletion layer 24 is formed in the n-type substrate region 21, and application of a voltage upon the gate electrode 26 develops a p-channel 27.

For fabrication of the LBCMOS, use of an SOI (Silicon On Insulator) substrate having the silicon substrate 1, the buried oxide film 2 and a single crystal silicon film is preferable.

As Fig. 1 clearly shows, the n-channel MOS transistor 10 for instance has an ordinary MOS transistor structure but also has a lateral bipolar transistor of the npn structure to which the n-type source region 12, p-type substrate region 11 but the partial depletion layer 14, and the n-type drain region 13 are inherent.

The n-channel MOS transistor 10 therefore operates in a mode (hybrid mode) which is the mixture of an operation mode of the MOS transistor and an operation mode of a bipolar transistor. This is similar to the p-channel MOS transistor 20 as well. The details of the hybrid mode will be described later.

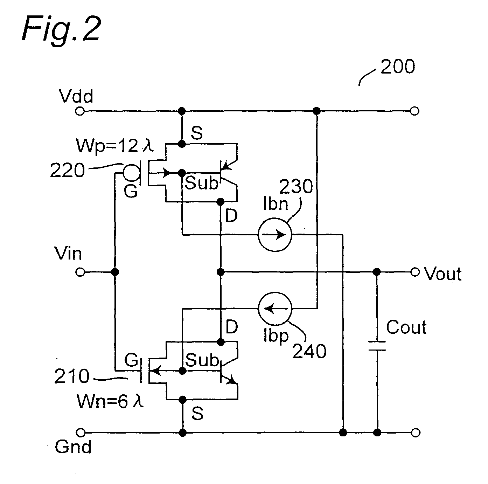

Fig. 2 shows an equivalent circuit to the lateral bipolar CMOS inverter circuit (LBCMOS) which is generally denoted at 200 according to the embodiment. In the LBCMOS 200, an n-channel MOS transistor 210 and a p-channel MOS transistor 220 are connected so that a CMOS inverter structure is formed. That is, the gates and the drains of the two transistors 210 and 220 are connected respectively with an input terminal Vin and an output terminal Vout. Further, the source of the p-channel MOS transistor 220 is connected with a voltage source Vdd and the source of the n-channel MOS transistor 210 is connected with a ground source Gnd.

The LBCMOS 200 further has two current sources Ibn 230 and Ibp 240. The current source Ibn 230 is connected with a substrate terminal (Sub) which is connected with an n-type substrate region (base) of the p-channel MOS transistor 220, and carries a forward current to the substrate terminal. On the other hand, the current source Ibp 240 is connected with a substrate terminal (Sub) which is connected with a p-type substrate region (base) of the n-channel MOS transistor 210, and similarly carries a forward current to the substrate terminal.

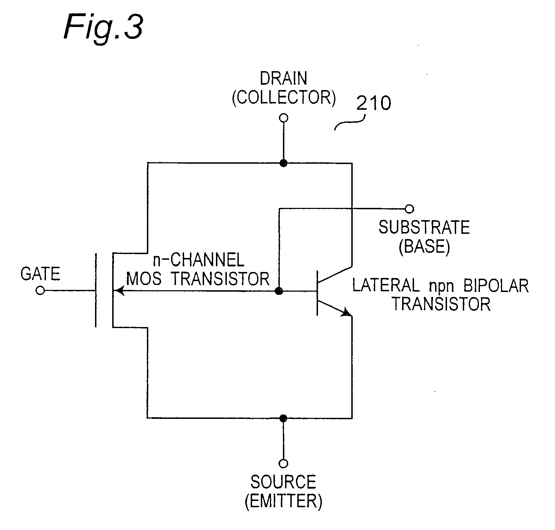

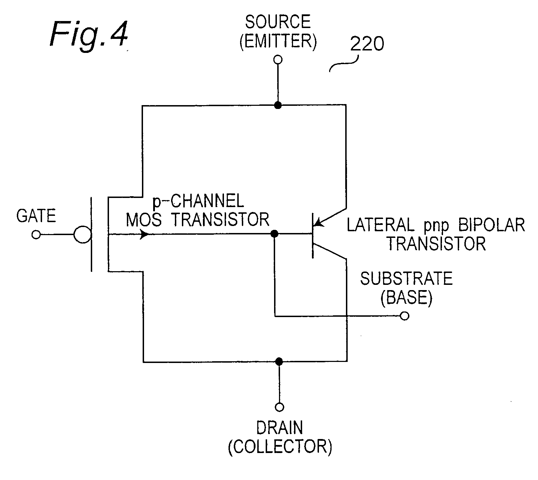

Fig. 3 shows an equivalent circuit to the 4-terminal n-channel MOS transistor 210 which is included in the LBCMOS 200 and which operates as a hybrid with an inherent npn lateral bipolar transistor. This transistor is called an n-channel LBMOS element. Meanwhile, Fig. 4 shows an equivalent circuit to the 4-terminal p-channel MOS transistor 220.

As Figs. 3 and 4 clearly show, the sources and the drains of the MOS transistors 210 and 220 serve also as the emitters and the collectors of the inherent bipolar transistors. The base regions of the bipolar transistors are connected with the substrate (base) terminals.

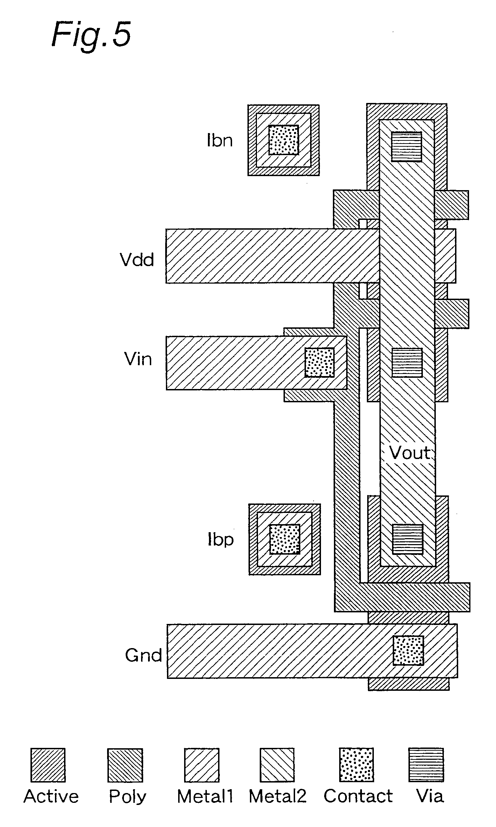

Fig. 5 shows the layout of the LBCMOS 200.

In the LBCMOS 200, in accordance with a $\lambda$ design rule, the channel width is that the minimum n-channel width is Wn = 6 $\lambda$ and the minimum p-channel width is Wp = 12 $\lambda$. For example, when $\lambda$ is 0.175 $\mu$m, the minimum size is Wn

= 1.05 μm and Wp = 2.1 μm.

In Fig. 5, input terminals of the current sources Ibn and Ibp are denoted as substrate contacts, and the isolation between an n-well and a p-well is assumed to be 6 λ.

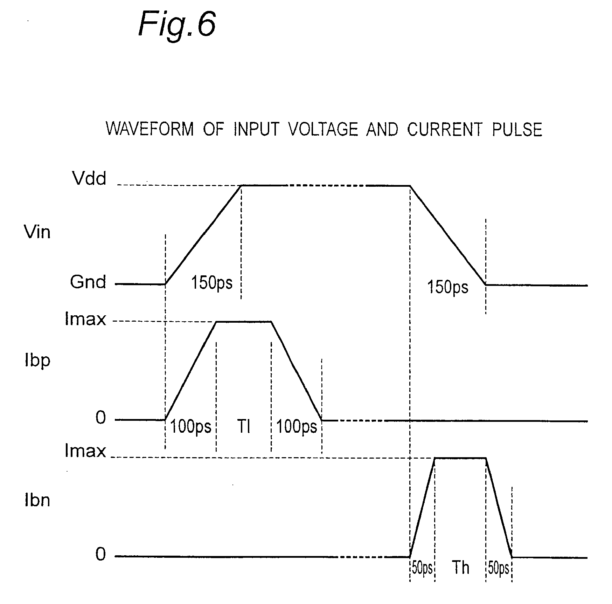

Fig. 6 shows the waveforms of an input voltage to an input terminal Vin and currents supplied from the current sources Ibp and Ibn as they are when the LBCMOS operates in the hybrid mode.

As shown in Fig. 6, first, the input voltage to the input terminal Vin switches to a high level (Vdd) from a low level (Gnd potential). Time necessary for switching (rising) is 150 ps. In synchronization to switching of the input voltage, a forward current is supplied from Ibp to the p-type substrate (base) terminal of the npn lateral bipolar transistor.

In this manner, the current source Ibp carries a trapezoidal pulse, which reaches the maximum current value of Imax, as a base current in synchronization only to switching of the input voltage of the inverter circuit from the low level to the high level, whereby the npn lateral bipolar transistor draws out a large collector current and the switching speed of the n-channel MOS increases. However, at this timing, the junction between the base (n) and the emitter (source) of the pnp lateral bipolar transistor is at zero bias and does not carry any current.

In a similar fashion, in synchronization only to switching of the input voltage of the inverter circuit from the high level to the low level (during the switching time of 150 ps), the current source Ibn, which supplies forward current to the n-type substrate (base) terminal of the pnp lateral bipolar transistor, carries a trapezoidal pulse which reaches the maximum current value of Imax as a base current. Hence, the pnp lateral bipolar transistor draws out a large collector current and the switching speed of the p-channel MOS increases. However, at this timing, the junction between the base (p) and the emitter (source) of the npn lateral bipolar transistor is at zero bias and does not carry any current.

Further, when the inverter circuit is in its steady state, that is, when the input voltage is approximately constant at the high level or the low level, zero bias is applied upon the base-emitter junctions of the two lateral bipolar transistors and none of the two lateral bipolar transistors carries any base current.

As clearly described above, in the LBCMOS according to the embodiment, when one of the transistors forming the inverter circuit operates at a high speed in its ON state and accordingly increases the consumption power, the other transistor remains OFF and does not consume any power. Further, when the increase of the consumption power exceeds a decrease of time delay, energy necessary for the entire LBCMOS to operate is reduced.

Although the foregoing has described that the switching (rising or falling) time of the input voltage at the input terminal Vin is 150 ps, this value is calculated from simulated waveforms of a ring oscillator circuit which has the minimum transistor width. Further, although the rising times (≒ falling times) of Ibp and Ibn are respectively 50 ps and 100 ps, this is in line with that the ratio of n-channel/p-channel MOS transistor width, namely the gate capacity ratio is 1 : 2. This is similar to an LBCMOS 300 which will be described later.

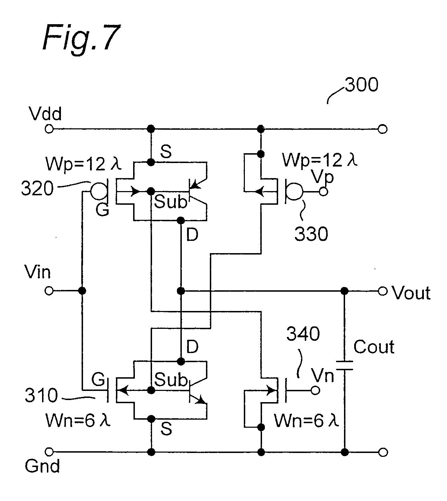

Fig. 7 is shows an equivalent circuit to the lateral bipolar CMOS (LBCMOS) inverter circuit which is generally denoted at 300 according to the embodiment.

As in the LBCMOS 200, an n-channel MOS transistor 310 and a p-channel MOS transistor 320 are connected so that a CMOS inverter structure is formed in the LBCMOS 300. Unlike in the LBCMOS 200, a pull-up p-channel MOS transistor 330 in which Wp = 12 λ = 2.1 μm and a pull-down n-channel MOS transistor 340 in which Wn = 6 λ = 1.05 μm are used as the two types of the current sources where λ = 0.175 μm for instance.

A drain terminal of the MOS transistor 330 is connected with a p-type substrate (base) terminal of the n-channel MOS transistor 310, and a source terminal and a substrate terminal of the MOS transistor 330 are both connected with the voltage source Vdd. In a similar manner, a drain terminal of the MOS transistor 340 is connected with an n-type substrate (base) terminal of the p-channel MOS transistor 320, and a source terminal and a substrate terminal of the MOS transistor 340 are each connected with the ground source Gnd.

In this structure, when a gate voltage Vp at the MOS transistor 330 and a gate voltage Vn at the MOS transistor 340 are controlled, a forward current flows to one of the substrate (base) terminals of the two MOS transistors 310 and 320 which form the inverter circuit. That is, as described later, control is exercised such that when a forward current flows to one substrate (base) terminal but does not flow to the other substrate (base) terminal.

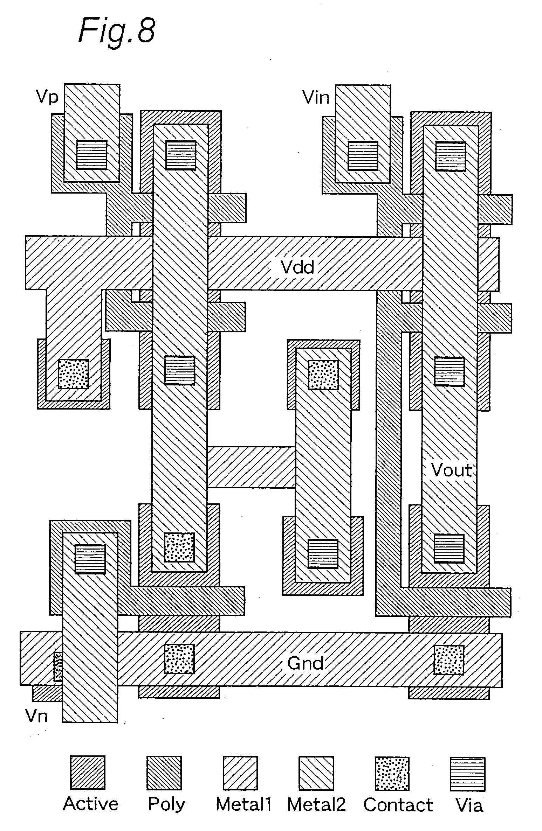

Fig. 8 shows the layout of this LBCMOS 300.

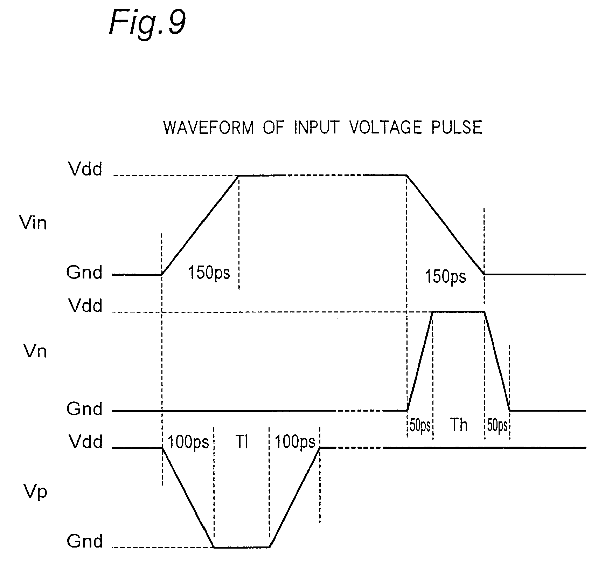

Fig. 9 shows the pulse waveforms of the input voltage fed to the input terminal Vin and the gate voltages Vp and Vn of the two current sources as they are when the LBCMOS 300 operates in the hybrid mode.

As shown in Fig. 9, first, the input voltage to the input terminal Vin switches to the high level (Vdd) from the low level (Gnd potential). Time necessary for switching (rising) is 150 ps. In synchronization to switching of the input voltage, the gate voltage Vp at the MOS transistor 330 changes from the high level (Vdd) to the low level (Gnd) and a trapezoidal pulse voltage returning back to the former high level (Vdd) after a certain time (T1) is supplied. In response, an approximately trapezoidal pulse current corresponding to this trapezoidal pulse voltage flows at the drain terminal of the MOS transistor 330. This pulse current, serving as the base current for the npn lateral bipolar transistor inherent in the n-channel MOS transistor 310, draws out a large collector current, and the switching speed of the n-channel MOS transistor 310 increases. On the other hand, the gate voltage Vn at the MOS transistor 340 is maintained at the low level, which controls so that the transistor stays OFF. No base current therefore flows in the p-channel MOS transistor 320 and the p-channel MOS transistor 320 remains OFF.

Next, as the input voltage Vin to the inverter circuit switches from the high level (Vdd) to the low level (Gnd), in synchronization to switching, the gate voltage Vn at the MOS transistor 340 changes from the low level (Gnd) to the high level (Vdd) and returns back to the former low level (Gnd) after a certain time (Th), thus in a trapezoidal pattern. Supply of this pulse voltage causes the drain terminal of the MOS transistor 340 to carry an approximately trapezoidal pulse current corresponding to this. This pulse current, serving as the base current for the pnp lateral bipolar transistor inherent in the n-channel MOS transistor 320, draws out a large collector current and the switching speed of the p-channel MOS transistor 320 increases.

Meanwhile, the gate voltage Vp at the MOS transistor 330 is maintained at the high level, which controls so that the transistor stays OFF. No base current therefore flows in the n-channel MOS transistor 310 and the n-channel MOS transistor 310 remains OFF.

Further, when the inverter circuit is in its steady state, that is, when the input voltage is approximately constant at the high level or the low level, zero bias is applied upon the base-emitter junctions of the two lateral bipolar transistors and none of the two lateral bipolar transistors carries any base current.

Thus, as in the LBCMOS 200, when one of the transistors forming the inverter circuit operates at a high speed in its ON state and accordingly increases the consumption power, the other transistor remains OFF and does not consume any power in the LBCMOS 300. Further, when the decrease of time delay exceeds the increase of the consumption power, energy necessary for the entire LBCMOS to operate is reduced.

<Example For Comparison>

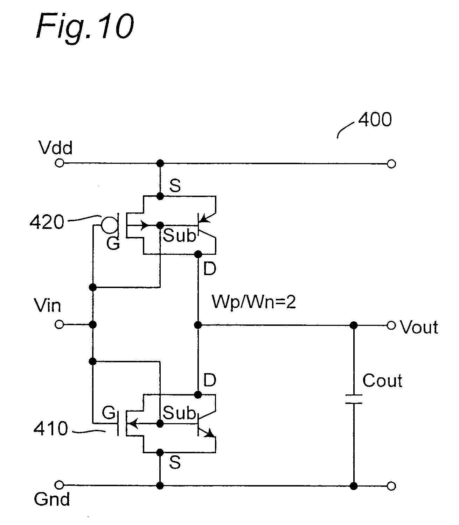

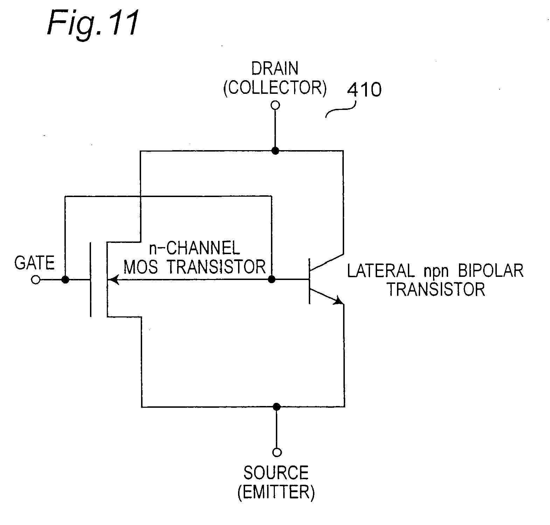

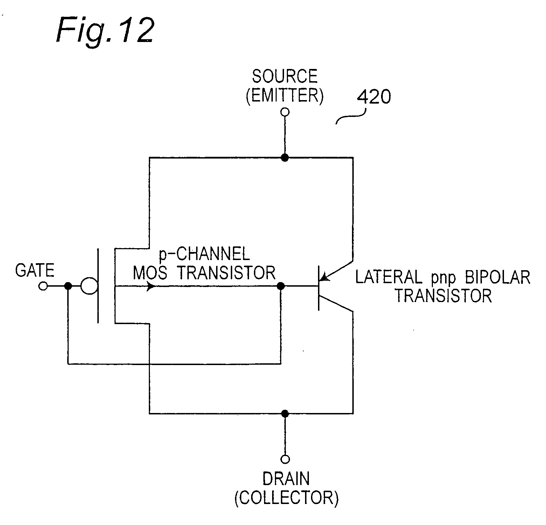

Fig. 10 shows an equivalent circuit to a conventional DTMOS (Dynamic Threshold Voltage CMOS) inverter circuit which is generally denoted at 400 according to an example for comparison. Figs. 11 and 12 show an equivalent circuit to an n-channel MOS transistor (hereinafter referred to as "DTMOS") 410 and an equivalent circuit to a p-channel DTMOS 420 which are included in a DTCMOS 400.

In the DTCMOS 400, the n-channel DTMOS 410 and the p-channel DTMOS 420 are connected so that a CMOS structure is obtained. The gates and the drains of the DTMOSs 410 and 420 are connected respectively with the input terminal Vin and the output terminal Vout. Meanwhile, the source of the p-channel DTMOS 420 is connected with the voltage source Vdd and the source of the n-channel DTMOS 410 is connected with the ground source Gnd.

Further, in the DTCMOS 400, the substrate (base) terminals of the two DTMOSs 410 and 420 are connected with the input terminal Vin.

The n-channel DTMOS 410, to which the gate terminal and the substrate terminal are always connected, will now be described. Application of a positive input voltage upon the gate electrode in the n-channel DTMOS 410 corresponds to application of a forward voltage upon the base-emitter junction of the npn lateral bipolar transistor inherent in the structure. The npn lateral bipolar transistor carries the base current dependent upon the value of the voltage applied upon this junction, that is, dependent upon the value of the gate voltage, and therefore, carries a collector current which is current amplification factor times as large as the base current. However, the voltage at the base-emitter junction is equal to or lower than a built-in voltage and so is the voltage source Vdd.

On the contrary, in the event that the source terminal and the drain terminal are at zero bias, even when the n-channel DTMOS 410 is not ON, application of a forward voltage upon the substrate terminal (namely, the terminal which functions as the base and also as the gate) gives rise to a base current which is large enough not to be ignored. Thus, power is consumed even in the steady state which does not cause switching in the DTCMOS 400.

Operations of the DTCMOS 400 shown in Fig. 10 will now be described.

In the DTCMOS 400, Wp/Wn = 2 is satisfied. Based on the 0.35 $\mu$m CMOS process, a mask size is that the channel length is Ln = Lp = 0.35 $\mu$m and the channel width is Wn = 1.05 $\mu$m (minimum channel width) and Wp = 2.1 $\mu$m.

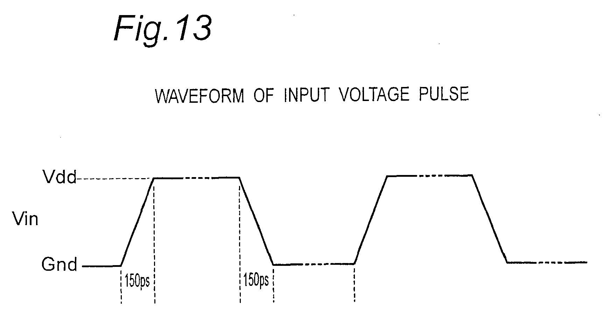

Fig. 13 shows the waveform of the input voltage from the input terminal Vin during operations of the DTCMOS 400. Although the rising time and the falling time are each 150 ps, this corresponds to the rising time (the falling time) calculated from simulation on a ring oscillator circuit which has the same size as a CMOS inverter.

Next, operations of the n-channel DTCMOS 410, which operates in the hybrid mode for an n-channel MOS and an npn bipolar transistor, are confirmed through circuit simulation. Simulation based on the 0.35 $\mu$m CMOS process was conducted on a BSIM 3v3 model using the following principal parameters.

n-channel MOS:

$$V_{T0} \ (n) \ = \ 0.178 \ V$$

$$K_1 = 0.47 \ V^{1/2}$$

$$K_2 = -0.057$$

$$\phi_s = 0.82 \ V$$

$$\mu_0 = 550 \ cm^2/V/Sec$$

$$t_{ox} = 7 \ nm$$

npn bipolar transistor:

$$h_{FE} = 100$$

$$I_s = 2 \times 10^{-15} A$$

$$Area = 1$$

According to "High-gain lateral bipolar action in a MOSFET structure" (IEEE Trans. Electron Devices, vol. ED-38, pp. 2487-2496, Nov. 1991) written by S. Verdonkt-Vandebroek et al., when Vdd is equal to or lower than 0.6 V, the current amplification factor $h_{FE}$ of the DTMOS is measured to be over 1000. It is considered the assumption in the present invention that $h_{FE}$ is 100 when Vdd is equal to or lower than 0.7 V can be realized easily.

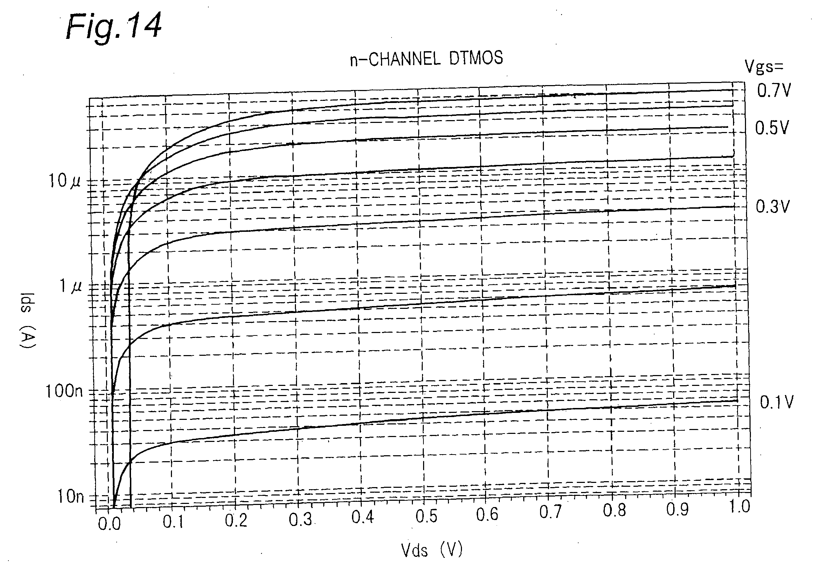

Fig. 14 shows a relationship between a current Ids and a voltage Vds as it is when Vgs changes from 0 V to 0.7 V in the n-channel DTCMOS 410 in which the width Wn of the transistor is 1.05 μm.

As seen in Fig. 14, when Vgs (= Vbe: base-emitter voltage) reaches 0.7 V, a forward base current abruptly increases exponentially, and therefore, the voltage-current relationship becomes discontinuous.

Following this, operations of the p-channel DTCMOS 420, which operates in the hybrid mode for a p-channel MOS and a pnp bipolar transistor, are confirmed through circuit simulation. Simulation based on the 0.35 μm CMOS process was similarly conducted on a BSIM 3v3 model using the following principal parameters.

p-channel MOS:

$$VT0 \ (p) = -0.238 \ V$$

$$K_1 = 0.45 \ V^{1/2}$$

$$K_2 = -0.03$$

$$\phi_s = 0.79 \ V$$

$$\mu_0 = 220 \ cm^2/V/Sec$$

$$t_{ox} = 7 \text{ nm}$$

pnp bipolar transistor:

$$h_{FE} = 100$$

$$I_s = 2 \times 10^{-15} \text{A}$$

$$\text{Area} = 2$$

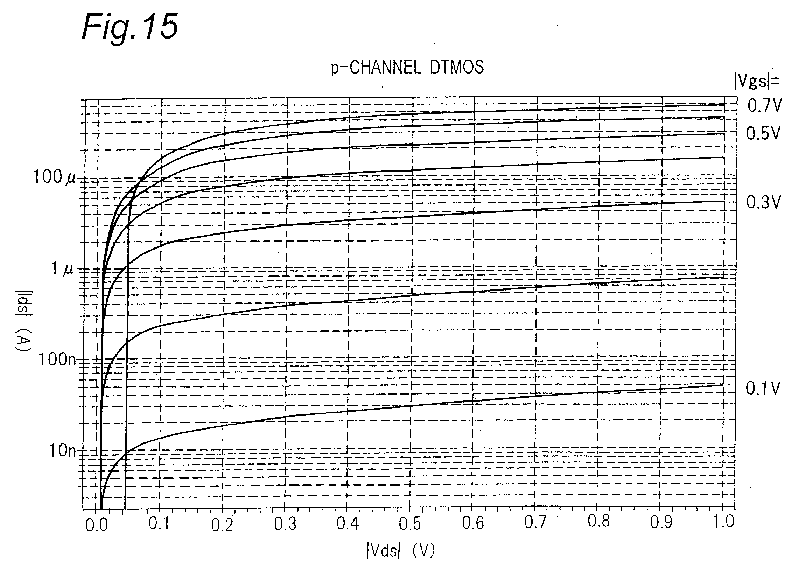

Fig. 15 shows relationship between a current |Ids| and voltage |Vds| as it is when |Vgs| changes from 0 V to 0.7 V in the p-channel DTCMOS 420. As seen in Fig. 15, when |Vgs| (= |Vbe|) reaches 0.7 V, a forward base current abruptly increases exponentially, and therefore, the voltage and the current become greatly discontinuous.

Next, circuit simulation results on the DTCMOS 400 including the DTCMOSs 410 and 420 are shown.

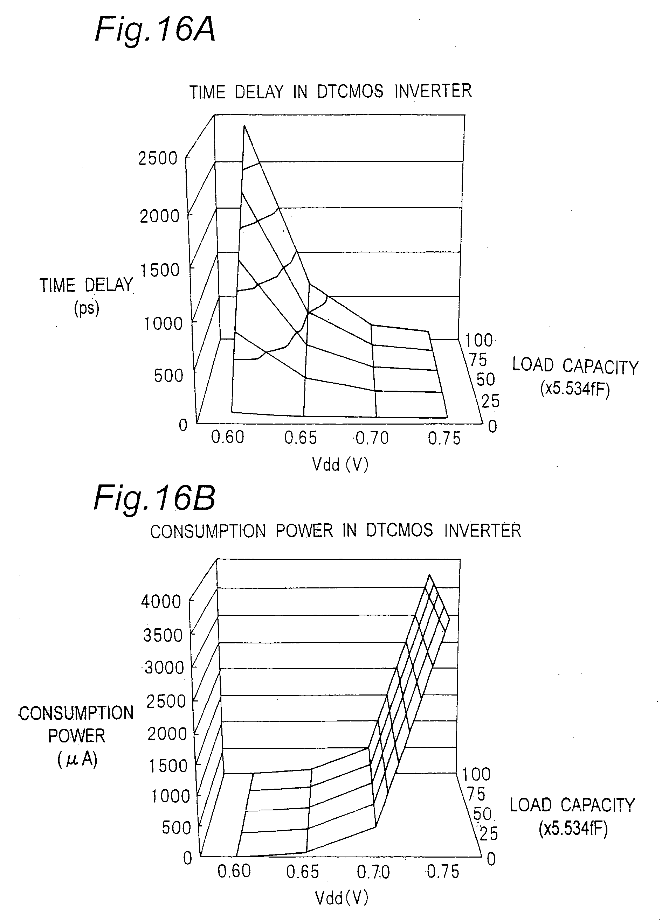

Figs. 16A and 16B show the time delay (which will hereinafter means average delay in an output at the time of rising and falling) and the consumption power in the DTCMOS inverter as they are when the load capacity and Vdd change.

From Figs. 16A and 16B, both the time delay and the consumption power are greatly dependent upon Vdd. When Vdd > 0.7 V in particular, the consumption power rapidly increases.

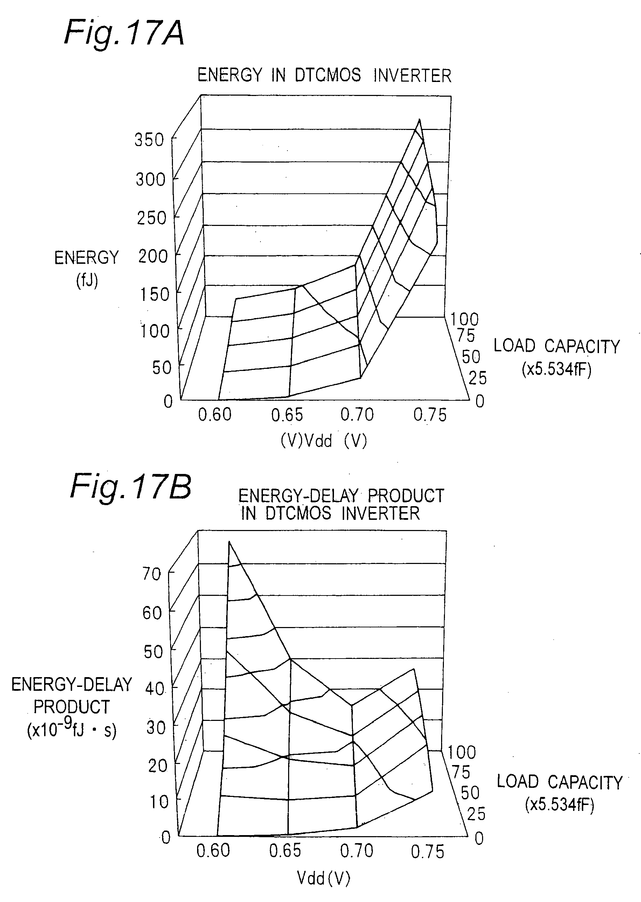

Figs. 17A and 17B show the energy and the energy-delay product in the DTCMOS inverter as they are when the load capacity and Vdd similarly change. Although it is possible to approximate the energy as (the consumption power X the time delay), since an increase of the consumption power exceeds a decrease of the time delay, the energy considerably increases when Vdd > 0.7 V holds.

The energy-delay product is obtained by multiplying the energy again by the time delay, and the energy-delay product is the smallest at the coordinates (0.6, 0) -> (0.65, 25) -> (0.7, 50) -> (0.7, 75) -> (0.7, 100) in Fig. 17B.

When the load capacity is equal to or smaller than 25, the value of the time delay can be regarded as approximately zero where Vdd < 0.65 V is satisfied. The value of the time delay increases when Vdd > 0.7 V, and this 0.7 V is the start of the increase. This is because a forward base current increases exponentially more than Vdd = 0.7 V and a collector current which is current amplification factor times as large as the base current consequently flows. While the upper limit of Vdd is 0.6 V in the non-patent literature 1 mentioned earlier, the upper limit is considered to be 0.7 V in the present invention.

<Embodiment>

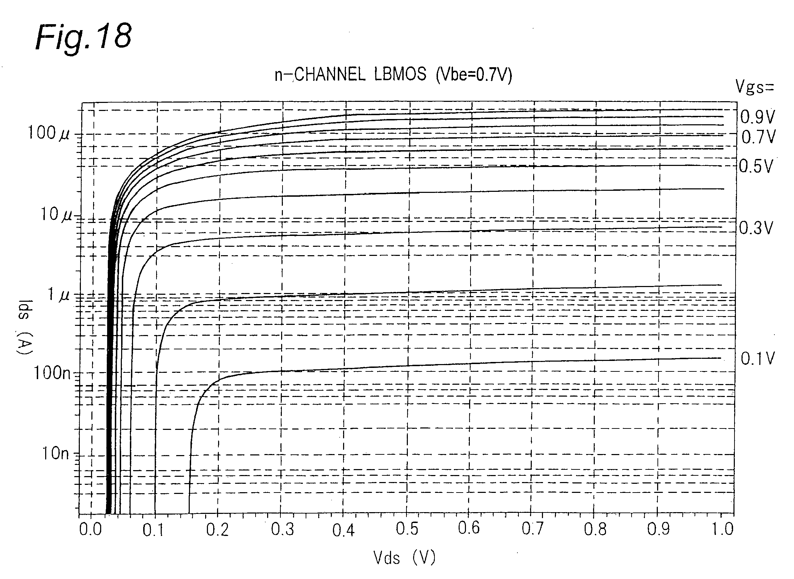

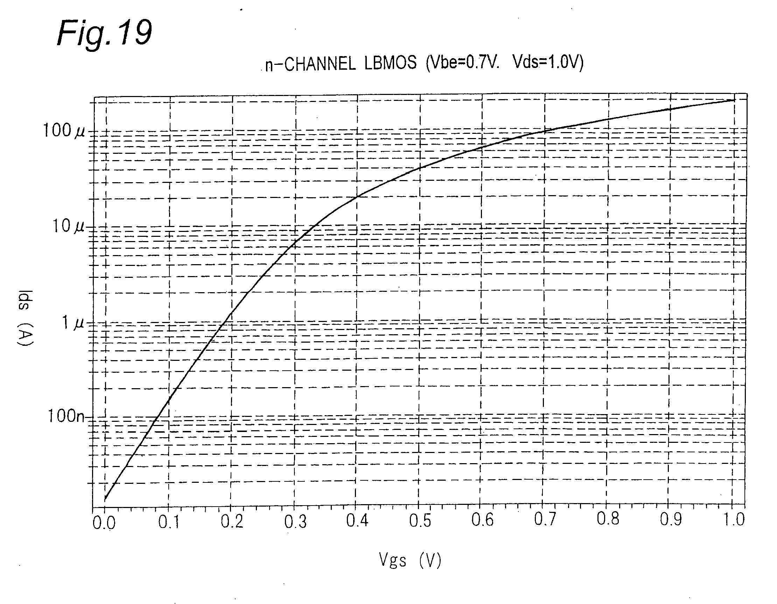

Fig. 18 shows a relationship between current Ids and voltage Vds as it is when Vbe = 0.7 V and when Vgs changes in an n-channel LBMOS (Wn = 1.05 $\mu$m). Fig. 19 shows a relationship between current Ids and voltage Vgs as it is when Vbe = 0.7 V and Vds = 1.0 V. In Figs. 18 and 19, a current is expressed as a logarithm along the vertical axis, and the current abruptly increases.

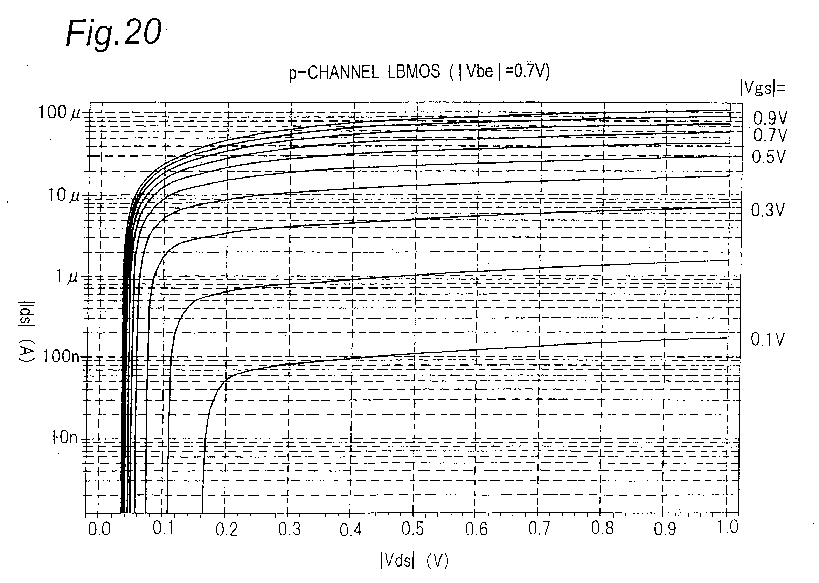

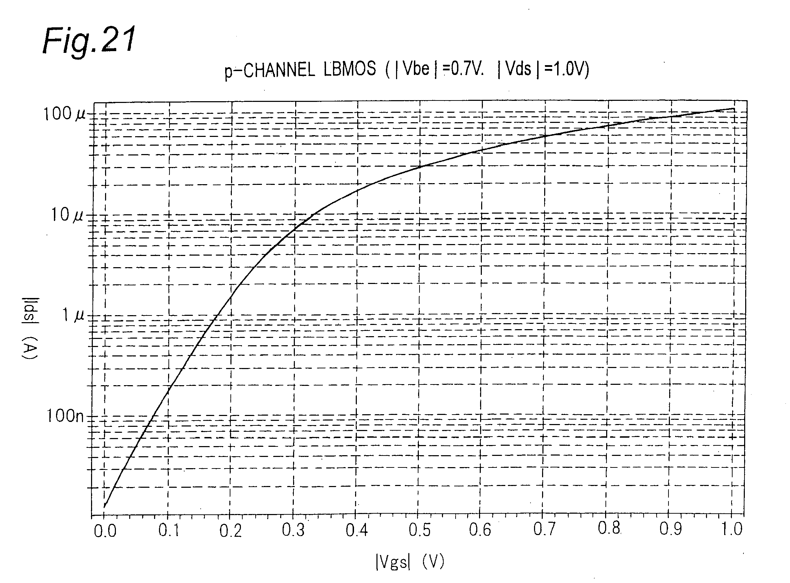

Fig. 20 shows a relationship between current |Ids| and voltage |Vds| as it is when |Vbe| = 0.7 V and when |Vgs| changes in a p-channel LBMOS (Wp = 2.1 $\mu$m). Fig. 21 shows a relationship between current |Ids| and voltage |Vgs| as it is when |Vbe| = 0.7 V and |Vds| = 1.0 V. A current is expressed as a logarithm along the vertical axis, and abruptly increases.

Next, a description will be given on circuit simulation results on an LBCMOS, in which the n-channel LBMOS and the p-channel LBMOS are connected so that a CMOS structure is obtained, during operations in the hybrid mode using the two types of the current sources.

In the circuit simulation, a current pulse condition is that when Vdd is at 0.7 V which is the upper limit in a DTCMOS, the maximum value of the current sources is 75$\mu$A while the load capacity is Cl = 0.5534 pF (= 100 $\times$ 5.534 fF: This value of 5.534 fF is the gate capacity value in the inverter circuit which has the minimum size.) and the intervals between times where the current level is the maximum are 100 ps.

Under this current pulse condition, a circuit simulation test was conducted regarding the capability of the LBCMOS inverter circuit in comparison with an ordinary CMOS and the DTCMOS described above as the example for comparison. In the hybrid mode, the current amplification factor $h_{FE}$ was set to 100.

Table 1 shows a result of the circuit simulation. Table 1 compares an ordinary CMOS, the DTCMOS described above as the example for comparison and the LBCMOS according to the present invention as for the time delay, the consumption power, the energy and the energy-delay product. CMOS/LBCMOS and DTCMOS/LBCMOS denote the ratios of the characteristics values which these circuits achieve. In Tables 2 through 4 below as well, the items compared in the simulation results are the same.

(Table 1) Vdd=0.7V, Cl=0.5334pF, Imax=75$\mu$A, Th=100ps

| | CMOS | DTCMOS | LBCMOS | CMOS/ LBCMOS | DTCMOS/ LBCMOS |
|---|---|---|---|---|---|
| DELAY (ps) | 4313.800 | 169.550 | 67.093 | 64.30 | 2.53 |
| CONSUMPTION POWER ($\mu$w) | 7.018 | 500.374 | 8.278 | 0.85 | 60.45 |
| ENERGY (fJ) | 30.274 | 84.838 | 0.555 | 54.55 | 152.86 |
| ENERGY-DELAY PRODUCT ($\times 10^{-9}$fJ·s) | 130.596 | 14.384 | 0.037 | 3529.62 | 388.76 |

As shown in Table 1, the LBCMOS inverter circuit which operates in the hybrid mode according to the present invention consumes power 18% more than the ordinary CMOS. However, the time delay is as small as 1/64, and hence, the operation speed is 64 times faster and the energy is 1/55.

Meanwhile, when compared against the DTCMOS, the operation speed is 2.5 times faster, the consumption power is 1/60 and the energy is 1/153. As described above, the DTCMOS inverter circuit malfunctions when Vdd > 0.7 V and consumes too much power even when Vdd = 0.7 V.

The LBCMOS inverter circuit operates the fastest and consumes low energy among these three types of the inverter circuits as described above.

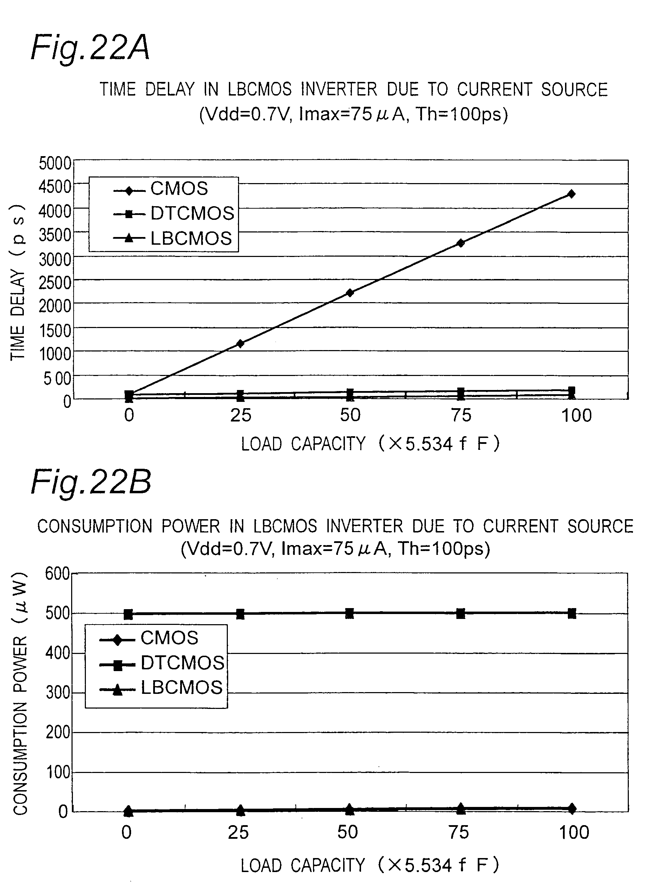

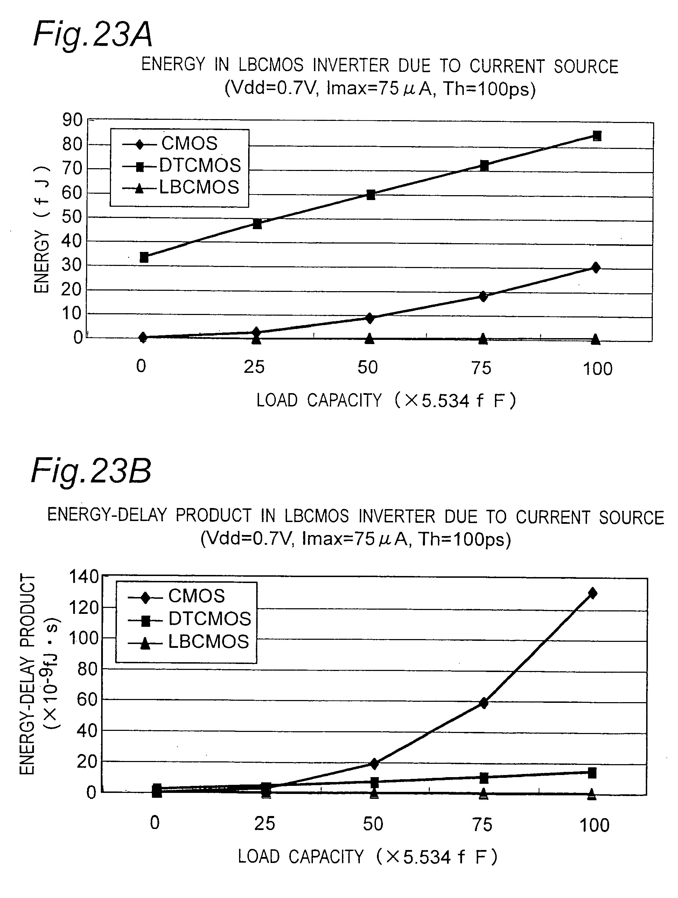

Figs. 22A and 22B show changes of the time delay and the consumption power in accordance with a change of the load capacity Cl from 0 to 100. Figs. 23A and 23B show changes of the energy and the energy-delay product in accordance with a change of the load capacity Cl from 0 to 100. The other conditions are the same as those in Table 1.

From these simulation results, it is seen that the time delay is very large in the CMOS and the consumption power is large in the DTCMOS.

In the DTCMOS inverter circuit, when Vdd rises to 1.0 V beyond the upper limit 0.7 V, the inverter circuit operates abnormally. However, the LBCMOS inverter circuit operates normally.

Table 2 shows a simulation result which was obtained when Vdd was fixed at 1.0 V while the load capacity was as large as Cl = 100 ($\times$ 5.534 fF) and the current sources exhibited Th = 100 ps at Imax = 75 $\mu$A.

(Table 2) Vdd=1.0V, Cl=0.5334pF, Imax=75$\mu$A, Th=100ps

| | CMOS | LBCMOS | CMOS/LBCMOS |
|---|---|---|---|
| DELAY (ps) | 2916.950 | 94.476 | 30.88 |
| CONSUMPTION POWER ($\mu$w) | 15.851 | 18.012 | 0.88 |
| ENERGY (fJ) | 46.236 | 1.702 | 27.17 |
| ENERGY-DELAY PRODUCT ($\times 10^{-9}$fJ·s) | 134.869 | 0.161 | 837.70 |

As shown in Table 2, the LBCMOS inverter circuit which operates in the hybrid mode according to the present invention consumes power 14% more than the ordinary CMOS. However, the time delay is as small as 1/31, and hence, the operation speed is 31 times faster. The energy is 1/27.

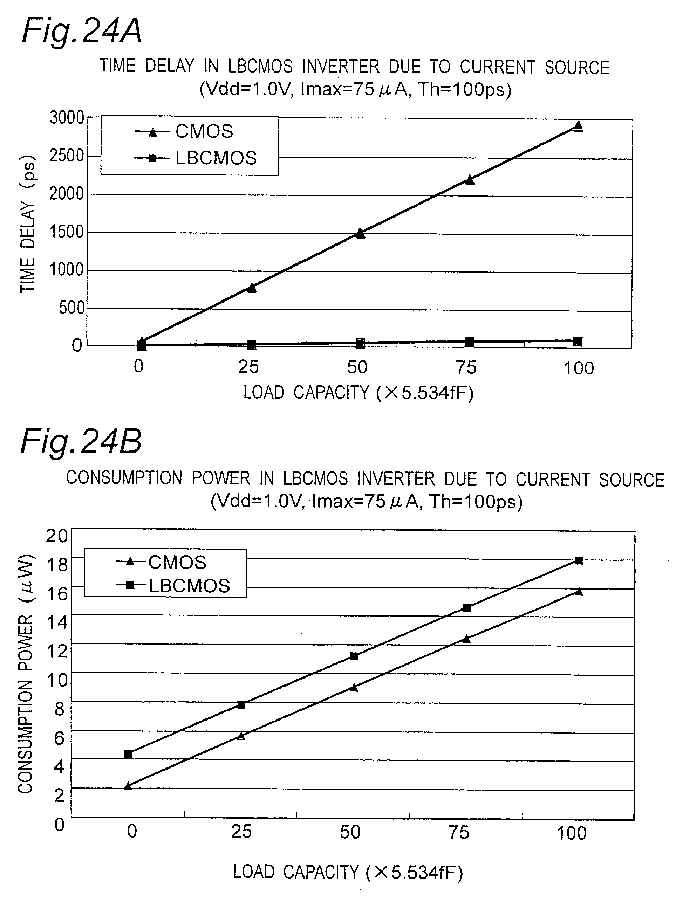

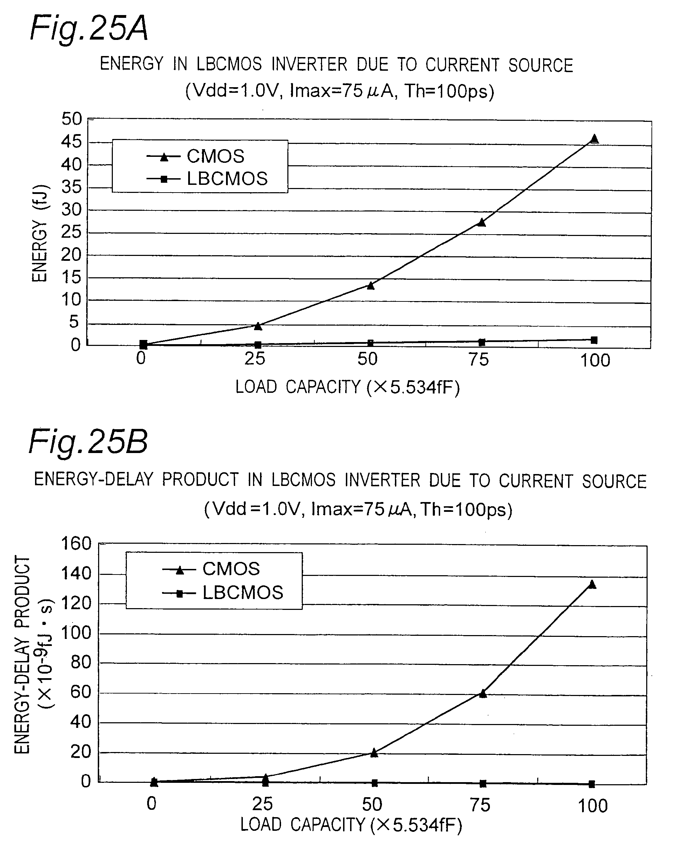

Figs. 24A and 24B show changes of the time delay and the consumption power in accordance with a change of the load capacity Cl from 0 to 100. Figs. 25A and 25B show changes of the energy and the energy-delay product in accordance with a change of the load capacity Cl from 0 to 100. The other conditions are the same as those in Table 2.

From these simulation results, it is seen that the CMOS inverter circuit is slightly superior in terms of the consumption power to the LBCMOS but creates dramatically large delay.

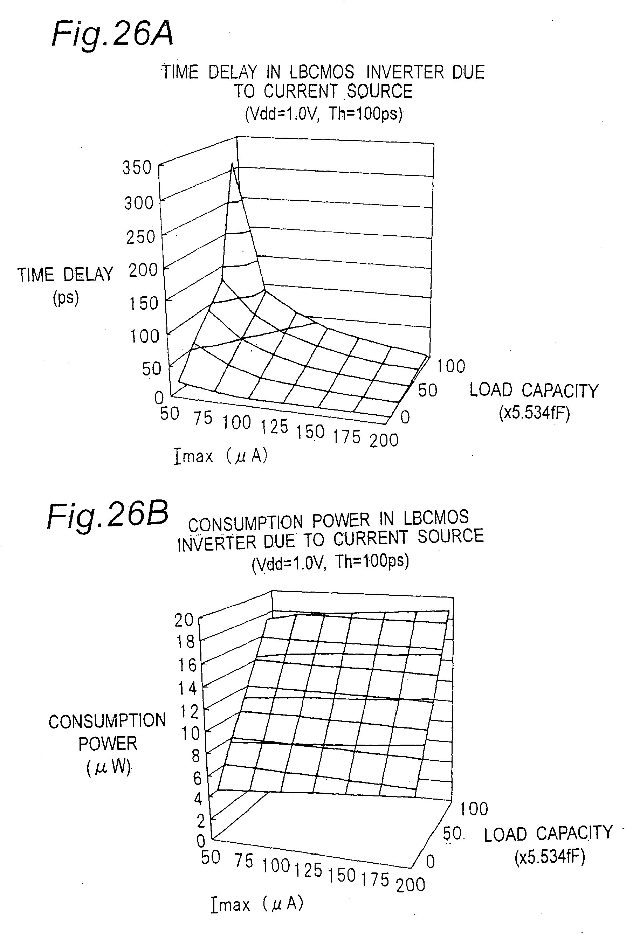

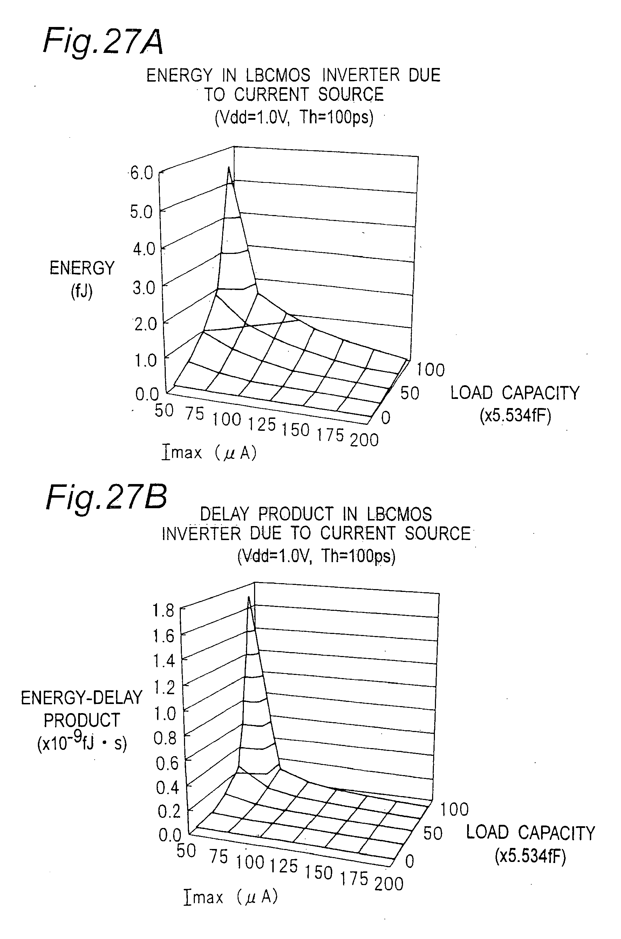

Figs. 26A and 26B show changes of the time delay and the consumption power in the LBCMOS inverter circuit in accordance with a change of Imax from 50 $\mu$A to 200 $\mu$A. Figs. 27A and 27B show changes of the energy and the energy-delay product in the LBCMOS inverter circuit in accordance with a similar change of Imax from 50 $\mu$A to 200 $\mu$A. Imax denotes the maximum current value supplied from the current source Ibp (See Fig. 6.).

From Fig. 26A, it is seen that the time delay changes abruptly when Imax is equal to or lower than 75 μA but changes slowly when Imax is equal to or lower than 75 μA. It then follows that supply from Ibp attains of an electric charge corresponding to the area size of a trapezoidal area Imax (= 75 μA) × 200 ps attains sufficiently fast switching is attained at the base terminal of the n-channel LBMOS.

Next, a description will be given on circuit simulation results on an LBCMOS, which uses pull-up/pull-down MOS transistors as the two types of the current sources, during operations in the hybrid mode.

In the circuit simulation, a current pulse condition is that when Vdd is at 0.7 V, the gate input voltages Vp and Vn within the pull-up/pull-down MOSs (n-channel MOS/p-channel MOS) switch between the high level and the low level at the switching intervals of 700 ps while the load capacity is Cl = 0.5534 pF (= 100 X 5.534 fF).

Under this current pulse condition, a circuit simulation test was conducted regarding the capability of the LBCMOS inverter circuit in comparison with an ordinary CMOS and the DTCMOS described above as the example for comparison. In the hybrid mode, the current amplification factor $h_{FE}$ was set to 100.

Table 3 shows a result of the circuit simulation. Table 3 compares an ordinary CMOS, the DTCMOS described above as the example for comparison and the LBCMOS according to the present invention as for the time delay, the consumption power, the energy and the energy-delay product. CMOS/LBCMOS and DTCMOS/LBCMOS denote the ratios of the characteristics values which these circuits achieve.

(Table 3) Vdd=0.7V, Cl=0.5334pF, Th=700ps

|  | CMOS | DTCMOS | LBCMOS | CMOS/ LBCMOS | DTCMOS/ LBCMOS |
|---|---|---|---|---|---|
| DELAY (ps) | 4236.350 | 169.550 | 681.945 | 6.21 | 0.25 |
| CONSUMPTION POWER (μw) | 7.319 | 500.374 | 8.176 | 0.90 | 61.20 |
| ENERGY (fJ) | 31.007 | 84.838 | 5.575 | 5.56 | 15.22 |
| ENERGY-DELAY PRODUCT ($\times 10^{-9}$fJ·s) | 131.356 | 14.384 | 3.802 | 34.55 | 3.78 |

As shown in Table 3, the LBCMOS inverter circuit which operates in the hybrid mode according to the present invention consumes power 12% more than the ordinary CMOS. However, the time delay is little smaller than 1/6, and hence, the operation speed is a high speed which is little more than 6 times faster. The energy is little more than 1/6.

Meanwhile, when compared against the DTCMOS, the operation speed is as slow as 1/4, the consumption power is 1/61 and the energy is 1/15. Under this condition, the DTMOS consumes extremely large power and it is therefore difficult to actually use the DTMOS.

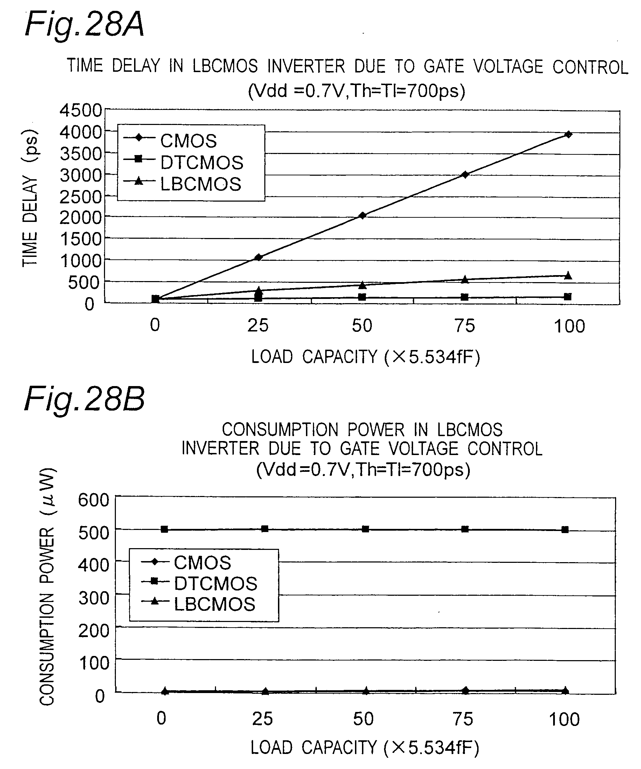

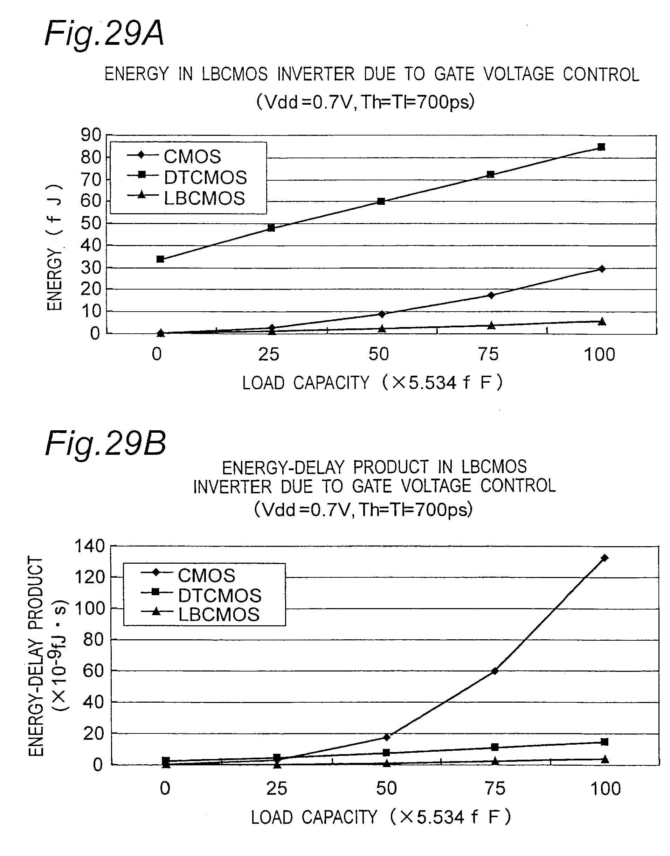

Figs. 28A and 28B show changes of the time delay and the consumption power in accordance with a change of the load capacity Cl from 0 to 100. Figs. 29A and 29B show changes of the energy and the energy-delay product in accordance with a change of the load capacity Cl from 0 to 100. The other conditions are the same as those in Table 3.

From these simulation results, it is seen that the time delay is very large in the CMOS inverter circuit and the consumption power is considerably large in the DTCMOS inverter circuit.

In the DTCMOS inverter circuit, when Vdd exceeds the upper limit of 0.7 V, the inverter circuit operates abnormally. However, the LBCMOS inverter circuit operates normally.

Table 4 shows a simulation result which was obtained when the hold time of the pulse voltage was Th = Tl = 700 ps while Vdd was fixed at 1.0 V and Cl = 100 (× 5.534 fF).

(Table 4) Vdd=1.0V, Cl=0.5334pF, Th=700ps

|  | CMOS | LBCMOS | CMOS/LBCMOS |
|---|---|---|---|
| DELAY (ps) | 2901.000 | 142.135 | 20.41 |
| CONSUMPTION POWER (μw) | 15.728 | 20.046 | 0.78 |
| ENERGY (fJ) | 45.628 | 2.849 | 16.01 |
| ENERGY-DELAY PRODUCT ($\times 10^{-9}$fJ·s) | 132.367 | 0.405 | 326.85 |

As shown in Table 4, the LBCMOS inverter circuit which operates in the hybrid mode according to the present invention consumes power 27% more than the ordinary CMOS. However, the time delay is 1/20, and hence, the operation speed is a high speed which is 20 times faster. The energy is 1/16.

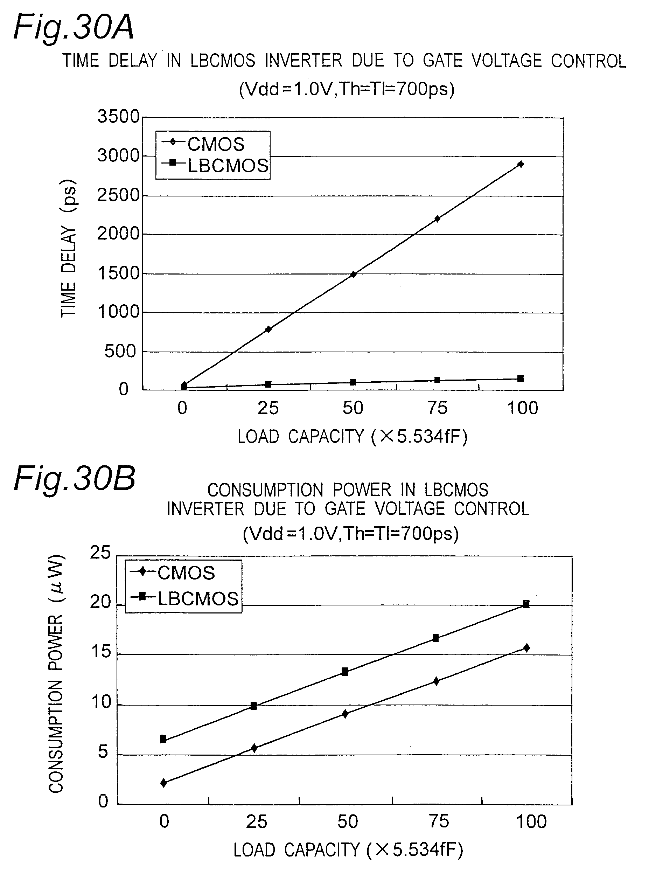

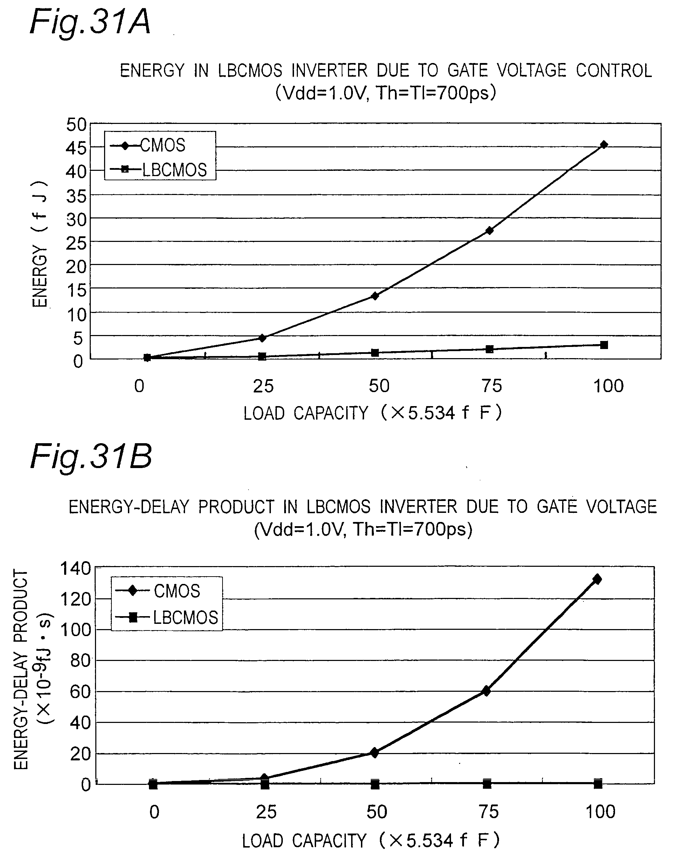

Figs. 30A and 30B show changes of the time delay and the consumption power in accordance with a change of the load capacity Cl from 0 to 100. Figs. 31A and 31B show changes of the energy and the energy-delay product in accordance with a change of the load capacity Cl from 0 to 100. The other conditions are the same as those in Table 4.

From these simulation results, it is seen that the CMOS inverter circuit is slightly superior in terms of the consumption power to the LBCMOS but gives rise to large delay.

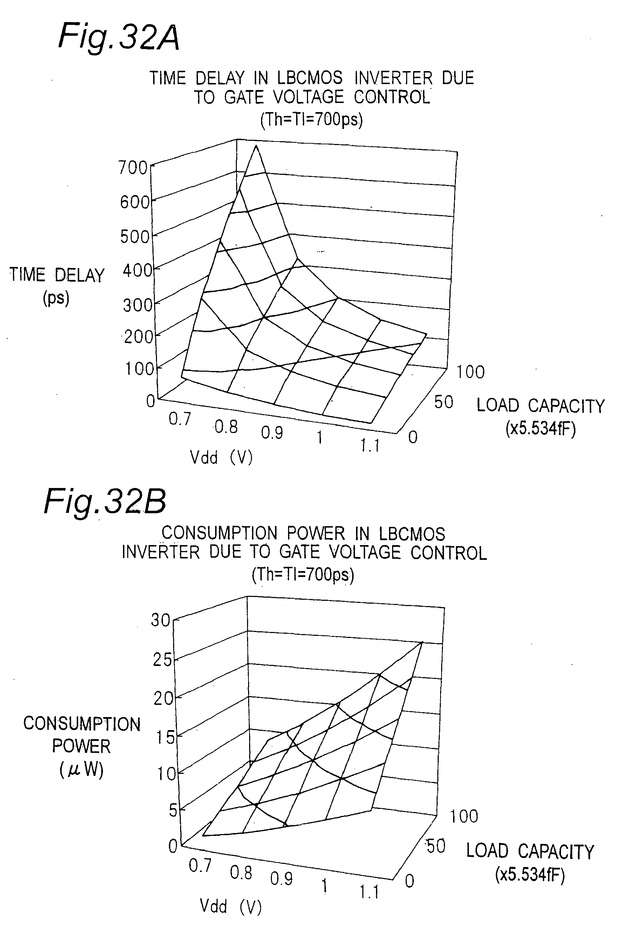

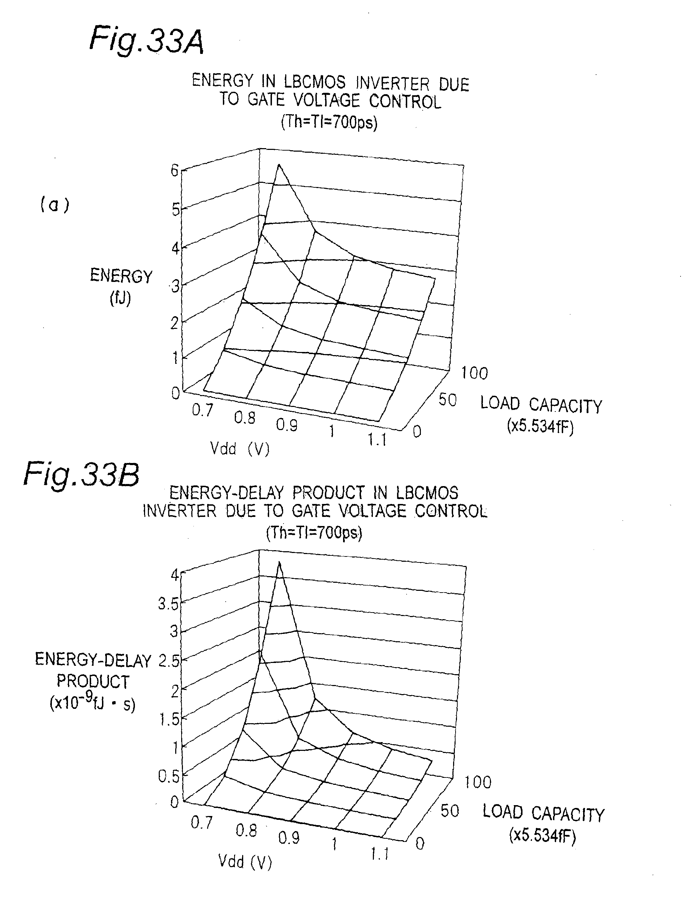

Figs. 32A and 32B show changes of the time delay and the consumption power in the LBCMOS inverter circuit as they are when the hold time of the pulse voltage Th (= Tl) is fixed to 700 ps and Vdd changes from 0.7 V to 1.1 V. Figs. 33A and 33B show changes of the energy and the energy-delay product as they are when Vdd changes from 0.7 V to 1.1 V under similar conditions.

As these drawings clearly show, the effect of reducing time delay becomes more effective as Vdd is increased, and even when Vdd = 1.1 V, the energy-delay product does not reach the minimum value.

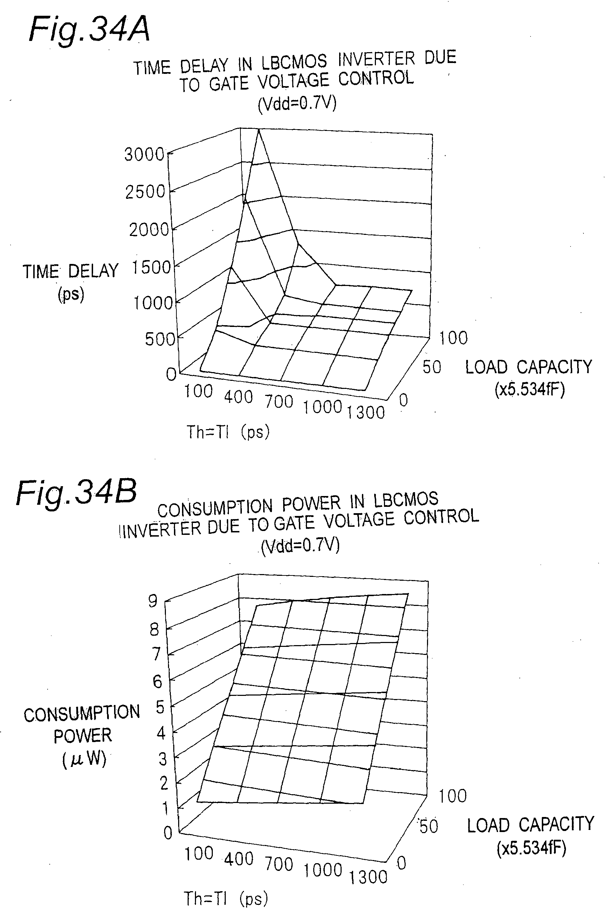

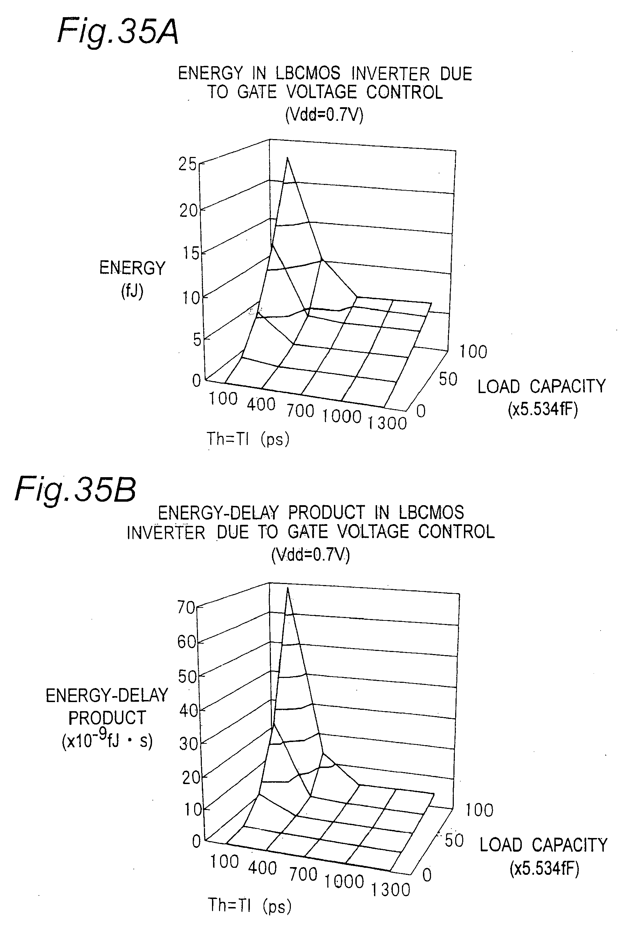

Figs. 34A and 34B show a simulation result on the time delay and the consumption power in the LBCMOS inverter circuit with Vdd fixed to 0.7 V and Th (= Tl) changed from 100 ps to 1300 ps. Figs. 35A and 35B show changes of the energy and the energy-delay product in the LBCMOS inverter circuit with Th (= Tl) changed from 100 ps to 1300 ps.

As these drawings show, the time delay does not change almost at all, the consumption power slightly increases, and the energy and the energy-delay product as well increase only slightly when Th (= Tl) is 700 ps or longer. It is therefore considered that an electric charge necessary for charge and discharge is supplied sufficiently to the LBCMOS inverter circuit even when the hold time Th (= Tl) is fixed to 700 ps, and therefore, the conclusion shown in Figs. 28 through 33 can be generalized.

As described above, the LBCMOS according to the embodiment is formed by the 4-terminal n-channel and p-channel MOS transistors, the CMOS formed by the npn and pnp lateral bipolar transistors inherent in these structures and the two current sources, and operates in the hybrid mode of the MOS transistor operations and the bipolar transistor operations. This greatly improves the driving capability of the MOS transistors which form the CMOS.

In this inverter circuit, as charge and discharge is attained at a high speed only during switching, a low-energy CMOS integrated circuit which operates fast is realized. To be more specific, the base terminals of the bipolar transistors inherent to the two MOS transistors are controlled, and in synchronization to switching of the input voltage to the CMOS inverter circuit, a forward current flows to the base terminal of one MOS transistor, a collector current is drawn out which is current amplification factor times as large as the base current, and the driving force greatly increases. At the same time, no base current flows to the base terminal of the other MOS transistor. Further, when the CMOS inverter circuit is in its steady state, no current flows to the base terminals of the both.

In a conventional CMOS standard cell library, a design method may be used which incorporates a hybrid-mode LBCMOS in an output from a standard cell which requires great driving force. That is, a CMOS standard cell library must contain, among others, a standard cell having a high driving capability which can cause switching of a large load such as a wiring RC and a fan-out capacity. Noting this, a library is equipped with a hybrid-mode LBCMOS which carries a forward base current and draws out a drain current which is current amplification factor times as large as the forward base current. Thus, concurrent use of a conventional CMOS standard cell which consumes low power and the high-speed low-energy LBCMOS according to the embodiment realizes a revolutionary CMOS standard cell library. For example, the LBCMOS is added to an output from a standard cell such as a logic gate having a large load on a critical path, a driving circuit for a bus and an output circuit of a block.

When the 0.35 $\mu$m CMOS process is used in particular, assuming a lateral bipolar operation wherein Vdd = 1.0 V and the current amplification factor is 100, the hybrid-mode LBCMOS operates 20 times as fast as an ordinary CMOS but consumes 1/16 of energy. Thus, the LBCMOS according to the embodiment greatly reduces the time delay and the energy at the same time.

**Claims**

1. A lateral bipolar CMOS integrated circuit comprising:

an inverter circuit comprising an n-channel MOS transistor and a p-channel MOS transistor, and having four terminals of:

a gate input terminal Vin connected with the gates of the n-channel MOS transistor and the p-channel MOS transistor;
an output terminal Vout connected with the drains of the n-channel MOS transistor and the p-channel MOS transistor;
a p-type base terminal connected with a p-type substrate of the n-channel MOS transistor; and
an n-type base terminal connected with an n-type substrate of the p-channel MOS transistor,

wherein the n-channel MOS transistor operates in a hybrid mode which is the hybrid of an operation mode of the MOS transistor and an operation mode of an npn lateral bipolar transistor which is inherent in the n-channel MOS transistor, and

the p-channel MOS transistor operates in a hybrid mode which is the hybrid of an operation mode of the MOS transistor and an operation mode of a pnp lateral bipolar transistor which is inherent in the p-channel MOS transistor.

2. The lateral bipolar CMOS integrated circuit according to claim 1, wherein the gate input terminal Vin, the p-type base terminal and the n-type base terminal are input terminals of the inverter circuit, and the output terminal Vout is an output terminal of the inverter circuit, and

the inverter circuit outputs, at the output terminal Vout, a high-level or low-level voltage fed to the gate input terminal Vin as an inverted level voltage.

3. The lateral bipolar CMOS integrated circuit according to claim 2, comprising a current source Ibp connected with the p-type base terminal of the n-channel MOS transistor and a current source Ibn connected with the n-type base terminal of the p-channel MOS transistor,

wherein currents from the current source Ibp and the current source Ibn are maintained at 0 when the input voltage to the gate input terminal Vin is approximately constant at a high level or low level,

when the input voltage to the gate input terminal Vin switches from the low level to the high level, a forward pulse current flows from the current source Ibp to the p-type base terminal in synchronization to switching, and

when the input voltage to the gate input terminal Vin switches from the high level to the low level, a forward pulse current flows from the current source Ibn to the n-type base terminal in synchronization to switching.

4. The lateral bipolar CMOS integrated circuit according to claim 3, further comprising a voltage source Vdd and a ground source Gnd,

wherein the current source Ibp is formed by a pull-up p-channel MOS transistor comprising a source terminal, a drain terminal and a substrate terminal, the drain terminal is connected with the p-type base terminal, and the source terminal and the substrate terminal are connected with the voltage source Vdd, and

the current source Ibn is formed by a pull-down n-channel MOS transistor comprising a source terminal, a drain terminal and a substrate terminal, the drain terminal is connected with the n-type base terminal, and the source terminal and the substrate terminal are connected with the ground source Gnd.

5. The lateral bipolar CMOS integrated circuit according to any one of claims 1 through 4,

wherein the inverter circuit comprising the n-channel MOS transistor and the p-channel MOS transistor is used as a CMOS standard cell in the operation mode of the MOS transistor, but is used in the hybrid mode when a large load is connected with an output from the CMOS standard cell.

Fig.1

# Fig.2

*Fig.3*

DRAIN
(COLLECTOR)  210

SUBSTRATE
(BASE)

GATE

n-CHANNEL
MOS TRANSISTOR

LATERAL npn BIPOLAR
TRANSISTOR

SOURCE
(EMITTER)

## Fig.4

SOURCE
(EMITTER)

220

GATE

p-CHANNEL
MOS TRANSISTOR

LATERAL pnp BIPOLAR
TRANSISTOR

SUBSTRATE
(BASE)

DRAIN
(COLLECTOR)

# Fig.5

# Fig.6

WAVEFORM OF INPUT VOLTAGE AND CURRENT PULSE

## Fig.7

*Fig.8*

Vp   Vin

Vdd

Vout

Gnd

Vn

| Active | Poly | Metal1 | Metal2 | Contact | Via |

## Fig.9

WAVEFORM OF INPUT VOLTAGE PULSE

# Fig.10

## Fig.11

DRAIN
(COLLECTOR)  410

GATE

n-CHANNEL
MOS TRANSISTOR

LATERAL npn BIPOLAR
TRANSISTOR

SOURCE
(EMITTER)

# Fig.12

SOURCE
(EMITTER)         420

GATE

p-CHANNEL
MOS TRANSISTOR        LATERAL pnp BIPOLAR
                      TRANSISTOR

DRAIN
(COLLECTOR)

*Fig.13*

WAVEFORM OF INPUT VOLTAGE PULSE

# Fig.14

n-CHANNEL DTMOS

EP 1 617 477 A1

Fig. 15

## *Fig.16A*

TIME DELAY IN DTCMOS INVERTER

## *Fig.16B*

CONSUMPTION POWER IN DTCMOS INVERTER

## Fig.17A

ENERGY IN DTCMOS INVERTER

ENERGY
(fJ)

LOAD CAPACITY
(x5.534fF)

(V)Vdd (V)

## Fig.17B

ENERGY-DELAY PRODUCT
IN DTCMOS INVERTER

ENERGY-DELAY
PRODUCT
$(x10^{-9}fJ \cdot s)$

LOAD CAPACITY
(x5.534fF)

Vdd(V)

Fig.18

## Fig.19

n-CHANNEL LBMOS (Vbe=0.7V. Vds=1.0V)

EP 1 617 477 A1

## Fig.20

p-CHANNEL LBMOS ( | Vbe | =0.7V)

EP 1 617 477 A1

## Fig.21

p-CHANNEL LBMOS ( |Vbe| =0.7V. |Vds| =1.0V)

EP 1 617 477 A1

*Fig.22A*

TIME DELAY IN LBCMOS INVERTER DUE TO CURRENT SOURCE
(Vdd=0.7V, Imax=75 $\mu$ A, Th=100ps)

*Fig.22B*

CONSUMPTION POWER IN LBCMOS INVERTER DUE TO CURRENT SOURCE
(Vdd=0.7V, Imax=75 $\mu$ A, Th=100ps)

## Fig.23A

ENERGY IN LBCMOS INVERTER DUE TO CURRENT SOURCE
(Vdd=0.7V, Imax=75$\mu$A, Th=100ps)

## Fig.23B

ENERGY-DELAY PRODUCT IN LBCMOS INVERTER DUE TO CURRENT SOURCE
(Vdd=0.7V, Imax=75$\mu$A, Th=100ps)

## Fig.24A

TIME DELAY IN LBCMOS INVERTER DUE TO CURRENT SOURCE
(Vdd=1.0V, Imax=75μA, Th=100ps)

## Fig.24B

CONSUMPTION POWER IN LBCMOS INVERTER DUE TO CURRENT SOURCE
(Vdd=1.0V, Imax=75μA, Th=100ps)

## Fig.25A

ENERGY IN LBCMOS INVERTER DUE TO CURRENT SOURCE
(Vdd=1.0V, Imax=75 μA, Th=100ps)

## Fig.25B

ENERGY-DELAY PRODUCT IN LBCMOS INVERTER DUE TO CURRENT SOURCE
(Vdd =1.0V, Imax=75 μA, Th=100ps)

## Fig.26A

TIME DELAY IN LBCMOS INVERTER DUE
TO CURRENT SOURCE
(Vdd=1.0V, Th=100ps)

## Fig.26B

CONSUMPTION POWER IN LBCMOS
INVERTER DUE TO CURRENT SOURCE
(Vdd=1.0V, Th=100ps)

## Fig.27A

ENERGY IN LBCMOS INVERTER DUE
TO CURRENT SOURCE
(Vdd=1.0V, Th=100ps)

ENERGY
(fJ)

LOAD CAPACITY
(x5.534fF)

Imax ($\mu$A)

## Fig.27B

DELAY PRODUCT IN LBCMOS
INVERTER DUE TO CURRENT SOURCE
(Vdd=1.0V, Th=100ps)

ENERGY-DELAY
PRODUCT
(x10$^{-9}$fJ · s)

LOAD CAPACITY
(x5.534fF)

Imax ($\mu$A)

## *Fig.28A*

TIME DELAY IN LBCMOS INVERTER DUE TO GATE VOLTAGE CONTROL
(Vdd =0.7V,Th=Tl=700ps)

## *Fig.28B*

CONSUMPTION POWER IN LBCMOS
INVERTER DUE TO GATE VOLTAGE CONTROL
(Vdd=0.7V,Th=Tl=700ps)

*Fig.29A*

ENERGY IN LBCMOS INVERTER DUE TO GATE VOLTAGE CONTROL
(Vdd=0.7V, Th=Tl=700ps)

*Fig.29B*

ENERGY-DELAY PRODUCT IN LBCMOS
INVERTER DUE TO GATE VOLTAGE CONTROL
(Vdd=0.7V, Th=Tl=700ps)

## *Fig.30A*

TIME DELAY IN LBCMOS INVERTER DUE TO GATE VOLTAGE CONTROL

(Vdd=1.0V,Th=Tl=700ps)

## *Fig.30B*

CONSUMPTION POWER IN LBCMOS
INVERTER DUE TO GATE VOLTAGE CONTROL
(Vdd=1.0V,Th=Tl=700ps)

## Fig.31A

ENERGY IN LBCMOS INVERTER DUE TO GATE VOLTAGE CONTROL
(Vdd=1.0V, Th=Tl=700ps)

## Fig.31B

ENERGY-DELAY PRODUCT IN LBCMOS INVERTER DUE TO GATE VOLTAGE
(Vdd=1.0V, Th=Tl=700ps)

## Fig.32A

TIME DELAY IN LBCMOS INVERTER DUE
TO GATE VOLTAGE CONTROL
(Th=Tl=700ps)

## Fig.32B

CONSUMPTION POWER IN LBCMOS
INVERTER DUE TO GATE VOLTAGE CONTROL
(Th=Tl=700ps)

## Fig.33A

ENERGY IN LBCMOS INVERTER DUE
TO GATE VOLTAGE CONTROL
(Th=Tl=700ps)

(a)

## Fig.33B

ENERGY-DELAY PRODUCT IN LBCMOS
INVERTER DUE TO GATE VOLTAGE CONTROL
(Th=Tl=700ps)

## Fig.34A

TIME DELAY IN LBCMOS INVERTER DUE
TO GATE VOLTAGE CONTROL
(Vdd=0.7V)

## Fig.34B

CONSUMPTION POWER IN LBCMOS
INVERTER DUE TO GATE VOLTAGE CONTROL
(Vdd=0.7V)

## Fig.35A

ENERGY IN LBCMOS INVERTER DUE
TO GATE VOLTAGE CONTROL
(Vdd=0.7V)

## Fig.35B

ENERGY-DELAY PRODUCT IN LBCMOS
INVERTER DUE TO GATE VOLTAGE CONTROL
(Vdd=0.7V)

## INTERNATIONAL SEARCH REPORT

| International application No. |
|---|
| PCT/JP2004/003208 |

A. CLASSIFICATION OF SUBJECT MATTER
    Int.Cl⁷ H01L27/092, H01L27/06, H01L29/786

According to International Patent Classification (IPC) or to both national classification and IPC

B. FIELDS SEARCHED

Minimum documentation searched (classification system followed by classification symbols)
    Int.Cl⁷ H01L27/092, H01L27/06, H01L29/786

Documentation searched other than minimum documentation to the extent that such documents are included in the fields searched
    Jitsuyo Shinan Koho          1922–1996  Jitsuyo Shinan Toroku Koho    1996–2004
    Kokai Jitsuyo Shinan Koho    1971–2004  Toroku Jitsuyo Shinan Koho    1994–2004

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 10-189957 A  (Mitsubishi Electric Corp.),<br>21 July, 1998 (21.07.98),<br>Par. Nos. [0015] to [0017]<br>Figs. 1 to 5<br>(Family: none) | 1-3,5<br>4 |
| Y | JP 2000-332132 A  (International Business<br>Machines Corp.),<br>30 November, 2000 (30.11.00),<br>Par. Nos. [0033] to [0038]; Figs. 7 to 9<br>& US 6239649 B1        & KR 1014764 A<br>& TW 441130 B | 4 |

☒ Further documents are listed in the continuation of Box C.    ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>02 June, 2004 (02.06.04) | Date of mailing of the international search report<br>22 June, 2004 (22.06.04) |
|---|---|
| Name and mailing address of the ISA/<br>    Japanese Patent Office | Authorized officer |
| Facsimile No. | Telephone No. |

Form PCT/ISA/210 (second sheet) (January 2004)

| INTERNATIONAL SEARCH REPORT | International application No. |
|---|---|
| | PCT/JP2004/003208 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 61-289658 A (Fujitsu Ltd.), 19 December, 1986 (19.12.86), Full text; all drawings (Family: none) | 1-5 |
| A | JP 10-229166 A (NEC Corp.), 25 August, 1998 (25.08.98), Full text; all drawings & US 5912591 A & CN 1190825 A & KR 98071343 A | 1-5 |

Form PCT/ISA/210 (continuation of second sheet) (January 2004)